(19) **Europäisches Patentamt**
**European Patent Office**
**Office européen des brevets**

(11) **EP 1 938 150 B1**

(12) **EUROPÄISCHE PATENTSCHRIFT**

(45) Veröffentlichungstag und Bekanntmachung des Hinweises auf die Patenterteilung:
**23.03.2011 Patentblatt 2011/12**

(21) Anmeldenummer: **06806336.1**

(22) Anmeldetag: **17.10.2006**

(51) Int Cl.:
***G03F 7/20*** *(2006.01)*

(86) Internationale Anmeldenummer:
**PCT/EP2006/010004**

(87) Internationale Veröffentlichungsnummer:
**WO 2007/045434 (26.04.2007 Gazette 2007/17)**

(54) **KOLLEKTOR FÜR BELEUCHTUNGSSYSTEME MIT EINER WELLENLÄNGE </= 193 NM**

COLLECTOR FOR LIGHTING SYSTEMS WITH A WAVELENGTH </= 193 NM

COLLECTEUR POUR SYSTÈMES D'ÉCLAIRAGE AYANT UNE LONGUEUR D'ONDE </= 193 NM

(84) Benannte Vertragsstaaten:
**DE FR IT NL**

(30) Priorität: **18.10.2005 US 727892 P**

(43) Veröffentlichungstag der Anmeldung:
**02.07.2008 Patentblatt 2008/27**

(73) Patentinhaber: **Carl Zeiss SMT GmbH**
**Rudolf-Eber-Strasse 2**
**73447 Oberkochen (DE)**

(72) Erfinder:
• **HAINZ, Joachim**
**82024 Taufkirchen (DE)**

• **ENDRES, Martin**
**89551 Königsbronn (DE)**
• **SINGER, Wolfgang**
**73431 Aalen (DE)**
• **KLEEMANN, Bernd**
**73431 Aalen (DE)**
• **BADER, Dieter**
**73571 Göggingen (DE)**

(74) Vertreter: **Carl Zeiss AG - Patentabteilung**
**Carl-Zeiss-Strasse 22**
**73447 Oberkochen (DE)**

(56) Entgegenhaltungen:
**EP-A- 1 239 330    WO-A-03/083579**
**WO-A1-99/57732**

EP 1 938 150 B1

## Beschreibung

Die vorliegende Anmeldung beansprucht die Priorität und den Benefit der USprovisional-Anmeldung 60/727,892, eingereicht am 18.10.2005 beim US Patentamt.

### Gebiet der Erfindung

Die Erfindung betrifft einen Kollektor für Beleuchtungssysteme mit einer Wellenlänge $\leq$ 193 nm, bevorzugt $\leq$ 126 nm, insbesondere bevorzugt Wellenlängen im EUV-Bereich zur Aufnahme des von einer Lichtquelle abgestrahlten Lichtes und zur Ausleuchtung eines Bereiches in einer Ebene.

Der Kollektor umfasst wenigstens eine erste Spiegelschale oder ein erstes Schalensegment sowie eine zweite Spiegelschale oder ein zweites Schalensegment, welches das Licht aufnimmt und in eine Ebene, die sich im Lichtweg hinter dem Kollektor befindet, eine erste Ausleuchtung und eine zweite Ausleuchtung zur Verfügung stellt.

Des Weiteren stellt die Erfindung auch ein Beleuchtungssystem, insbesondere mit einem derartigen Kollektor sowie eine Projektionsbelichtungsanlage mit einem erfindungsgemäßen Beleuchtungssystem und ein Verfahren zur Belichtung von Mikrostrukturen zur Verfügung.

### Beschreibung des Standes der Technik

Zum Sammeln von Licht, das von einer Lichtquelle abgestrahlt wird, und zur Ausleuchtung eines Bereiches in einer Ebene sind aus einer Vielzahl von Anmeldungen Kollektoren bekannt geworden, die eine objektseitige Apertur aufweisen, die das von einer Lichtquelle abgestrahlte Licht aufnimmt, sowie eine Vielzahl von rotationssymmetrischen Spiegelschalen, die um eine gemeinsame Rotationsachse angeordnet sind, wobei jeder Spiegelschale ein Ringaperturelement der objektseitigen Apertur zugeordnet ist. Der auszuleuchtende Bereich in einer im Lichtweg hinter dem Kollektor liegenden Ebene besteht aus Ringelementen. Ein derartiger Kollektor ist z. B. in der US2003- 0043455A1 und in der WO 03/083579 A gezeigt. Bei den in der US 2003-0043455A1 gezeigten Kollektoren überlappen die Ringelemente in der ausgeleuchteten Ebene nicht und schließen weitgehend kontinuierlich aneinander an.

Werden derartige Kollektoren, wie in der US-2003-0043455A1 gezeigt in Beleuchtungsoptiken für die Mikrolithographie, beispielsweise die EUV-Lithographie, wie sie in der WO 99/57732, oder der WO 02/065482 gezeigt sind, eingesetzt, so ergibt sich das Problem, das aufgrund der ringförmigen Ausleuchtung sehr hohe geometrische Lichtverluste im Beleuchtungssystem von etwa 40 % auftreten, d.h. mehr als 40 % des von der vom Kollektor gesammelten Lichtes werden nicht von den Feldrasterelementen aufgenommen. Ein weiterer Nachteil derartiger Systeme ist, das bei einer Betrachtung der scanintegrierten Uniformität in der Feldebene des Beleuchtungssystems sich zwar die Beiträge sämtlicher Schalen zu einem homogenen Verlauf addieren, jedoch dieser summierte Verlauf und damit auch die Uniformität des auszuleuchtenden Feldes sehr stark von den Ausleuchtungsbeiträgen der einzelnen Schalen abhängen und bei Änderungen der Ausleuchtungsbeiträge der einzelnen Schalen, die beispielsweise durch eine thermale Deformation der Kollektorschalen oder eine Degradation der reflektierenden Schichten auf den Kollektorschalen induziert sein kann, die Uniformität stark beeinflusst wird.

### Beschreibung der Erfindung

Aufgabe der Erfindung ist es somit, diese Nachteile des Standes der Technik, insbesondere in Form der PCT/EP 02/00608 (Veröffentlichungsnummer WO 02/065482 A2) oder der US-2003-0043455A1 zu vermeiden. Insbesondere soll ein Kollektor angegeben werden, der sich dadurch auszeichnet, dass wenn er in einem Beleuchtungssystem, beispielsweise für die Mikrolithographie verwendet wird, der Lichtverlust gegenüber den Systemen wie in der US-2003-0043455A1 offenbart, minimiert wird.

Gemäß eines weiteren Aspektes der Erfindung soll die starke Änderung der Uniformität in der Feldebene des Beleuchtungssystems bei Verwendung eines aus dem Stand der Technik bekannten Kollektors bei thermaler Deformation der Kollektorschalen oder Degradation der Schichten auf den Kollektorschalen minimiert werden.

In einem ersten Aspekt der Erfindung wird bei einem genesteten Kollektor, d. h. bei einem Kollektor, der wenigstens zwei Spiegelschalen umfasst, die ineinander angeordnet sind, der Lichtverlust dadurch minimiert, dass die Spiegelschalen geschlossene Spiegelflächen sind, die einen rotationssymmetrischen Anteil und einen nicht rotationssymmetrischen Anteil umfassen. Ein Kollektor, bei dem zwei Spiegelschalen ineinander angeordnet sind, wird auch als genesteter Kollektor bezeichnet.

Unter geschlossener Spiegelfläche wird in vorliegender Anmeldung eine zusammenhängende Fläche verstanden. Eine zusammenhängende Fläche ist eine Fläche, die einen umlaufenden Azimutwinkel $\Phi$ von 0 bis $2\pi$ aufweist.

In einer weitergebildeten Ausführungsform umfasst der rotationssymmetrische Anteil beispielsweise einen ersten Anteil, der z.B. als erstes Segment ausgebildet ist, eines Rotationshyperboloides und ein zweiten Anteil, der z.B.

als zweites Segment ausgebildet ist, eines Rotationsellipsoides. Der nicht rotationssymmetrische Anteil wird beispielsweise zum zweiten Anteil hinzuaddiert oder abgezogen, wobei die Anteile in Form von Segmenten vorliegen. Alternativ kann der nicht rotationssymmetrische Anteil zu dem ersten Segment oder zu beiden Segmenten hinzuaddiert oder abgezogen werden.

Alternativ zu oben genannter Ausführungsform wird ein Kollektor vorgeschlagen, der aus einer ersten und einer benachbarten zweiten Fläche besteht. Benachbart heißt vorliegend, dass die beiden Flächen einen gewissen geometrischen Abstand zueinander aufweisen und sich nicht durchdringen. Wenn Flächen einen genesteten Aufbau haben, d.h. ineinander liegen, ist dies ein spezieller Aufbau des allgemeinen Aufbaues mit zwei zueinander beabstandeten Flächen.

Jede der beiden Flächen ist mit ihren jeweiligen Flächenpunkten durch eine Achse definiert und die jeweiligen Abstände der Punkte in Bezug auf diese Achse. Als Achse wird vorliegend für jede Fläche eine z-Achse eines Koordinatensystems angesehen. Auf der z-Achse senkrecht steht jeweils eine x-y-Ebene, die in Polarkoordinaten durch einen Radius r und einen Azimutwinkel $\Phi$ definiert werden kann. Für eine rotationssymmetrische Fläche ist der Abstand der Flächenpunkte von der z-Achse lediglich eine Funktion in Abhängigkeit von z-Achse, d.h. die Form der Fläche in z-Richtung wird durch eine Flächenfunktion K(z) beschrieben. Die Krümmung der Fläche senkrecht zur z-Richtung ist dadurch durch einen Kreis mit dem Radius K(z) gegeben. Beispiele für derartige Flächen sind Rotationshyperboloide, Rotaionsellipsoide oder Rotationsparabeln oder allgemein die Mantelfläche eines Rotationskörpers. Bei einer Rotionsparabel wäre beispielsweise die Funktion der Krümmung senkrecht zur z-Achse ein Kreisbogen mit einem Radius der an unterschiedlichen Stellen entlang der z-Achse dann gegeben ist als

$$K(z) = az^2 + bz + z_0,$$

wobei die einzelnen Parameter a, b oder $z_0$ auch den Wert 0 annehmen können.

Die Krümmung entlang der z-Achse ist durch die zweite Ableitung K''(z) gegeben.

Ganz allgemein ist die Krümmung einer Fläche aber eine Funktion von z und des Azimutwinkels $\Phi$, wobei der Azimutwinkel zwischen 0 und $2\pi$ variieren kann. Werden geschlossene Flächen beschrieben, so nimmt der Azimutwinkel $\Phi$ Werte von 0 bis $2\pi$ an. Wird lediglich ein Schalensegment und keine geschlossene Spiegelfläche beschrieben, so nimmt der Azimutwinkel $\Phi$ Werte zwischen 0 und $2\pi$, beispielsweise von $\pi/2$ bis $\pi$ an. Somit kann eine Fläche in Ihrer allgemeinsten Form durch eine von z und dem Azimutwinkel $\Phi$ abhängige Flächenfunktion K(z,$\Phi$) beschrieben werden, d.h. K(z,$\Phi$)beschreibt den senkrechten Abstand eines Punktes auf der Fläche im Abstand K(z,$\Phi$) an der Stelle z der zugeordneten z-Achse unter dem Azimutwinkel $\Phi$.

Der Lichtverlust in einem Beleuchtungssystem kann nun dadurch minimiert werden, dass der Kollektor zur Aufnahme von Licht mindestens zwei benachbarte Flächen umfasst, die jeweils eine an die Abstrahlcharakteristik einer oder mehrerer Lichtquelle(n) und die in einer Ebene auszuleuchtende Fläche angepasste Flächenfunktion K(z,$\Phi$) aufweisen.

Jeder der wenigstens zwei benachbarten Flächen kann je eine z-Achse zugeordnet sein. So ist der ersten Fläche eine erste z-Achse und der zweiten Fläche eine zweite z-Achse zugeordnet. Die erste und zweite z-Achse kann identisch sein. Dann liegt eine gemeinsame z-Achse für beide Spiegelflächen vor. Die erste und zweite z-Achse kann aber auch räumlich unterschiedlich angeordnet sein, aber parallel zueinander liegen. Als weitere Variante ist es auch denkbar, dass die erste und die zweite z-Achse einen Winkel miteinander einschließen.

Wenn anstelle von geschlossenen Spiegelflächen, Schalensegmente verwandt werden, können die Schalensegmente räumlich verschoben werden, um unterschiedliche Ausleuchtungen in der Ebene, in der bevorzugt die Feldrasterelemente angeordnet sind, zur Verfügung zu stellen. Sind unterschiedlichen Feldrasterelementen unterschiedliche Pupillenrasterelemente in einem doppelt facettierten Beleuchtungssystem zugeordnet, so können durch unterschiedliche Ausleuchtungen von Feldfacetten unterschiedliche Pupillenausleuchtungen realisiert werden.

In einer weitergebildeten Ausführungsform der Erfindung weisen die Spiegelschalen eine Symmetrieachse auf. Die Symmetrieachse kann auch gemeinsame Symmetrieachse für alle Spiegelschalen sein.

Bevorzugt kann wenigstens eine Spiegelschale eine Symmetrie bezüglich der Symmetrieachse aufweisen. Möglich sind n-zählige Symmetrien, wobei n eine ganze natürliche Zahl ist. So liegt beispielsweise für n=2 eine zweizählige Symmetrie vor. Bei einer zweizähligen Symmetrie wird nach einer Drehung um 180° um die Symmetrieachse Identität erreicht und nach einer Drehung um 360° die Ausgangslage. Im Schnitt quer zur Symmetrieachse weist eine Schale mit zweizähliger Symmetrie beispielsweise eine Ellipsenform auf. Alternativ sind auch beispielsweise drei, vier, fünf, sechs, sieben oder achtzählige Symmetrien möglich. Bei einer vierzähligen Symmetrie liegt Identität bei Drehung um 90° vor, bei einer sechszähligen Symmetrie liegt Identität bei Drehung um 60° und bei einer achtzähligen Symmetrie liegt Identität bei Drehung um 45° vor.

Da die genesteten Kollektorsysteme immer eine minimale Kollektionsapertur $NA_{min}$ zur Aufnahme von Licht einer Lichtquelle und damit eine Mittenobskuration besitzen, kann mit Vorteil zur Blockung von Streulicht die Anordnung einer Blende innerhalb der Spiegelschale, die am nächsten zur gemeinsamen Achse ist, vorgesehen sein.

Bevorzugt sind die Kollektoren derart ausgelegt, dass mehr als 50 %, insbesondere mehr als 60%, ganz bevorzugt mehr als 70 %, insbesondere bevorzugt mehr als 80 %, ganz besonders bevorzugt mehr als 90 %, insbesondere bevorzugt mehr als 92%, ganz bevorzugt mehr als 95% des von dem Kollektor gesammelten Lichtes von in der auszuleuchtenden Ebene angeordneten Rasterelementen eines facettierten optischen Elementes aufgenommen werden.

In einem weiteren Aspekt sind die erste Spiegelschale oder das erste Schalensegment, welche das Licht von der Lichtquelle in eine erste Ausleuchtung in der auszuleuchtenden Ebene lenkt, und die zweite Spiegelschale oder das zweite Schalensegment, welche das Licht in eine zweite Ausleuchtung in der Ebene lenkt, derart ausgebildet, dass erste und zweite Ausleuchtung einen Abstand zueinander aufweisen. Beispielsweise ist dieser Abstand zwischen der ersten Ausleuchtung und der zweiten Ausleuchtung größer als 1 mm.

Insbesondere ist der Abstand der durch die Anordnung der Spiegel bzw. der Spiegelsegmente erreicht wird, derart gewählt, dass bei einer thermalen Deformation des Spiegels oder Spiegelsegmente die unterschiedlichen ausgeleuchteten Bereiche nicht überlappen. Des Weiteren ist sichergestellt, dass eine derartige Überlappung auch dann nicht eintritt, wenn sich z. B. die Abstrahtcharakteristik der Lichtquelle ändert.

Zum Beispiel beträgt der Abstand mehr als 5mm, da thermische Verformungen aufgrund der Aufheizung der Kollektorschalen oder Kollektorschalensegmente durch die Lichtquelle um etwa 120 Kelvin erfahrungsgemäß zu einer Verschiebung oder Verbreiterung der Ausleuchtung in der Feldebene, d.h. in der Ebene, in der das erste facettierte optische Elemente eines Beleuchtungssystems angeordnet ist, um etwa 5mm führen. Die Verformungen des Kollektors haben keinen Einfluss auf die äußere Form der ausgeleuchteten Fläche in der Ebene 114 oder auf die Energieverteilung innerhalb des ausgeleuchteten Feldes.

Gemäß einem weiteren Aspekt der Erfindung wird ein Beleuchtungssystem zur Verfügung gestellt, bei dem eine Vielzahl von Rasterelementen in einer Ebene des Beleuchtungssystems in einem ersten Bereich angeordnet sind. Das Beleuchtungssystem umfasst des Weiteren einen Kollektor, der das Licht der Lichtquelle aufnimmt und einen zweiten Bereich in der Ebene, in der die Vielzahl von Rasterelementen angeordnet sind, ausleuchtet. Der Kollektor ist derart aufgebaut, dass der zweite Bereich den ersten Bereich weitgehend vollständig überdeckt.

In einer besonders vorteilhaften Ausführungsform der Erfindung weist der erste Bereich eine erste Fläche B und der zweite Bereich eine zweite Fläche A auf. Zum Beispiel ist die Größe des vom Kollektor ausgeleuchteten zweiten Bereiches größer als die Größe des Bereiches, in dem die ersten Rasterelemente angeordnet sind, beispielweise gilt die folgende Beziehung:

$$B \leq A \leq 1{,}2 \bullet B,$$

insbesondere

$$1{,}05 \bullet B \leq A \leq 1{,}1 \bullet B$$

Dadurch, dass der erste Bereich, mit einer ersten Fläche B in dem die Rasterelemente angeordnet sind, weitgehend überdeckend ausgeleuchtet wird, wird der geometrische Lichtverlust minimiert.

Gemäß einem weiteren Aspekt der Erfindung wird der Kollektor derart ausgestaltet, dass die Ausleuchtung des Lichtes in der Ebene eine nicht rotationssymmetrische Ausleuchtung , beispielsweise eine im Wesentlichen rechteckige Ausleuchtung, insbesondere eine praktisch quadratische Ausleuchtung ist. Auf dieser Art und Weise kann der geometrische Lichtverlust, der bei Systemen wie in der US 2003-0043455A1 offenbart, mehr als 40 % beträgt, auf einen geometrischen Lichtverlust von kleiner 30%, bevorzugt kleiner 20%, insbesondere kleiner 10 % reduziert werden, da die Form der Ausleuchtung an die Form der Feldrasterelemente angepasst ist.

Eine Ausleuchtung in der Ebene, in der das facettierte optische Element mit Feldrasterelementen angeordnet ist, die von der Rotationssymmetrie abweicht, hat zur Folge, dass die von den Feldrasterelementen ausgebildeten Lichtquellenbilder astigmatisch abgebildet werden, d. h. die Lichtquellenbilder sind verzeichnet und weichen damit von der Punktform ab. Hierdurch kommt es zu Lichtverlusten. Bevorzugt ist daher vorgesehen, dass die einzelnen Feldrasterelemente eine Asphärizität aufweisen, beispielsweise asphärische Spiegel sind. Hierdurch kann der Astigmatismus der Abbildung der Lichtquellen korrigiert werden. Bevorzugt wird bei einer Vielzahl von Feldrasterelementen auf dem ersten facettierten optischen Element die Asphärizität jedes einzelnen Feldrasterelementes derart angepasst, dass das von dem Feldrasterelement ausgebildete Lichtquellenbild weitgehend verzeichnungsfrei in eine Pupillenebene abgebildet wird. Weitgehend verzeichnungsfrei heißt, dass z. B. die Verwaschung bzw. Verzeichnung des Lichtquellenbildes beispielsweise mit einem Durchmesser von 5mm in der Pupillenebene maximal 100 $\mu$m beträgt, d. h. maximal 2% des Durchmessers des Lichtquellenbildes, z. B. in der Pupillenebene, in die die Lichtquelle abgebildet wird.

In einer besonders bevorzugten Ausgestaltung der Erfindung hat daher das erste facettierte optische Element mit Feldrasterelementen wenigstens zwei Feldrasterelemente mit unterschiedlichen Asphärizitäten.

In einer ersten Ausführungsform sind die Schalen des Kollektors als geschlossene Flächen ausgebildet, beispielsweise als Schalen, die ineinander um eine Achse (HA) angeordnet sind. Eine solche Anordnung wird im allgemeinen als eine genestete Anordnung bezeichnet.

Die geschlossenen Flächen erzeugen in der Ebene eine im Wesentlichen rechteckige Ausleuchtung, wenn die einzelnen Kollektorschalen beispielsweise astigmatisch deformiert sind.

In einer besonderen Ausführungsform der Erfindung, die eine im Wesentlichen rechteckige, bevorzugt quadratische Ausleuchtung in der Ebene erzeugt, wird dem rotationssymmetrischen Anteil, durch den die Kollektorschale dargestellt werden kann, ein nicht- rotationssymmetrischer Anteil überlagert, so dass eine derartige astigmatische Deformation erreicht wird.

Der geometrische Lichtverlust beträgt bei einer derartigen weitgehend rechteckigen Ausleuchtung der Ebene weniger als 30%, insbesondere weniger als 20 %, ganz bevorzugt weniger als 10 %.

Alternativ zu einer Ausgestaltung des Kollektors mit einer geschlossenen Kollektorschale kann der Kollektor auch aus einzelnen Schalensegmenten bestehen.

Diese Schalen sind im Wesentlichen im Lichtweg von der Lichtquelle zur auszuleuchtenden Ebene so angeordnet, dass sie möglichst viel Licht von der Lichtquelle aufnehmen und in der auszuleuchtenden Ebene eine weitgehend rechteckige Ausleuchtung erzeugen. Besonders bevorzugt sind die Ausleuchtungen, die durch die einzelnen Schalensegmente vorgenommen werden, voneinander beabstandet und zwar derart, dass durch den Abstand der Ausleuchtungen verhindert wird, dass die Beiträge einzelner Schalensegmente sich bei einer thermalen Verformung oder einer Veränderung der Abstrahlung der Lichtquelle überlappen. Bevorzugt beträgt dieser Abstand mehr als 1 mm, ganz bevorzugt mehr als 5 mm.

Wird ein derartiger Kollektor mit Schalensegmenten in einem Beleuchtungssystem verwandt, das neben einem ersten facettierten optischen Element mit einer Vielzahl von Feldrasterelementen ein weiteres facettiertes optisches Element mit einer Vielzahl von Pupillenrasterelementen umfasst, wobei je eine erste Vielzahl von Feldrasterelementen gemäß einer ersten Zuordnung einer ersten Vielzahl von Pupillenrasterelementen und je eine zweite Vielzahl von Feldrasterelementen einer zweiten Vielzahl von Pupillenrasterelementen einer zweiten Zuordnung zugeordnet ist, so kann durch ein Verbringen der Schalensegmente in unterschiedliche Positionen die Zuordnung von Feld- und Pupillenfacetten geändert und so in der Austrittspupille des Beleuchtungssystems eine unterschiedliche Ausleuchtung der Austrittspupille erreicht werden.

Dies führt wiederum dazu, dass mit Hilfe einer derartigen Anordnung unterschiedliche Settings, wie beispielsweise in der US 6,658,084 B2 gezeigt, eingestellt werden können.

Durch eine derartige Ausgestaltung lässt sich ohne nennenswerten Lichtverlust das Beleuchtungssetting verändern.

Alternativ zu der Einstellung unterschiedlicher Ausleuchtungen in der Austrittspupille durch ein Verbringen von Schalensegmenten in unterschiedliche Positionen ist es möglich die Einstellung durch ein optisches Einstellelement vorzunehmen. Bei Verwendung eines optischen Einstellelementes kann der Kollektor als Kollektor mit geschlossenen Spiegelschalen ausgeführt sein. Das optische Einstellelement ist bevorzugt im Lichtweg vor dem ersten facettierten optischen Element angeordnet. Je nachdem in welche Position das optische Element verbracht wird, werden unterschiedliche Bereiche des ersten facettierten Elementes ausgeleuchtet. Da die Feldrasterelemente auf dem ersten facettierten optischen Element unterschiedlichen Pupillenrasterelementen zugeordnet sind, kann durch Auswahl unterschiedlicher Feldrasterelemente mit Hilfe des optischen Einstellelementes eine Auswahl von Pupillenrasterelementen getroffen und damit das beispielsweise Setting in einer Austrittspupille des Beleuchtungssystems eingestellt werden. Das optische Einstellelement kann beispielsweise ein Dachkantspiegel sein, der um eine Achse drehbar gelagert ist. In einer ersten Einstellung reflektiert der Spiegel beispielsweise lediglich das vom Kollektor aufgenommene Lichtbündel. Der Dachkantspiegel wirkt also als Planspiegel. In einer zweiten Einstellung des Dachkantspiegels wird das vom Kollektor auf den Dachkantspiegel auftreffende Lichtbüschel in zwei Lichtbüschel zerlegt, die unterschiedliche Bereiche des ersten facettierten optischen Elements ausleuchten. Da unterschiedliche Feldrasterelemente unterschiedlichen Pupillenrasterelementen zugeordnet sind, kann hierdurch die Pupillenausleuchtung, beispielsweise das Setting in der Austrittspupille eingestellt werden.

Alternativ zum Verbringen in unterschiedliche Positionen eines einzigen optischen Elementes können auch verschieden Spiegelelemente in den Strahlengang verbracht werden, die dann das Licht auf unterschiedliche Bereiche des Feldfacettenspiegels lenken. Auf diese Art und Weise können wieder unterschiedliche Settingeinstellungen realisiert werden.

Alternativ zu einer Deformation der Spiegelschalen des Kollektors oder einer Ausbildung des Kollektors mit Spiegelsegmenten, die in oder nahe der Ebene, in der die Feldrasterelemente eines ersten facettierten optischen Elementes angeordnet sind und eine im Wesentlichen rechteckige Ausleuchtung ausbilden, kann in einer alternativen Ausführungsform der Erfindung vorgesehen sein, dass der Kollektor einzelne Kollektorschalen aufweist, die in einer vor der Ebene, in der das facettierte optische Element angeordnet ist, angeordneten Ebene im Wesentlichen ringförmige Ausleuchtung erzeugt. Diese im Wesentlichen eine ringförmige Ausleuchtung kann durch Einbringen eines optischen Elementes im Strahlengang vor der Ebene, in der die ringförmige Ausleuchtung ausgebildet wird und in der das facettierte optische Element angeordnet ist, in eine im Wesentlichen rechteckige Ausleuchtung transformiert werden.

In einer ersten Ausführungsform ist ein derartiges optisches Element beispielsweise ein asphärischer Spiegel.

Alternativ hierzu kann, wie in der US-2002-0186811 A1 beschrieben, ein Gitter mit optischer Wirkung im Strahlengang vom Kollektor zur Ebene in der das facettierte optische Element angeordnet ist, vorgesehen sein. Durch die optische Wirkung des Gitters wird die im Wesentlichen ringförmige Ausleuchtung in eine im Wesentlichen rechteckige Ausleuchtung in der Ebene, in der das facettierte optische Element mit Feldrasterelementen angeordnet ist, transformiert. Des Weiteren wird durch das Gitter gleichzeitig eine spektrale Filterung, wie beispielsweise in der US 2002-0186811 A1 beschrieben, vorgenommen, so dass in dem im Lichtweg hinter dem Gitter liegenden Beleuchtungssystem nur Licht der Nutzwellenlänge von beispielsweise 13,5 nm vorliegt. Unter Licht einer Nutzwellenlänge wird in vorliegender Anmeldung das Licht der Wellenlänge verstanden mit dem in einer Mikrolithographie-Projektionsbelichtungsanlage ein in der Objektebene beleuchtetes Objekt, beispielsweise ein Retikel in die Bildebene beispielsweise mit Hilfe eines Projektionsobjektives abgebildet wird.

Bevorzugt umfasst ein erfindungsgemäßes Beleuchtungssystem eine Lichtquelle mit einer weitgehend isotropen Abstrahlcharakteristik. Bei isotrop abstrahlenden Lichtquellen, d.h. Lichtquellen, die in alle Raumrichtung gleich viel Energie abstrahlen kann durch den erfindungsgemäßen Kollektor erreicht werden, dass gleiche von der Lichtquelle aufgenommene Winkelsegmente auf gleich große Flächen in einer Ebene, beispielsweise der auszuleuchtenden Ebene, abgebildet werden und diese Flächen mit einer konstanten Energiedichte bestrahlt werden.

Für den Fachmann ist es selbstverständlich, dass die Vielzahl der Einzelmaßnahmen, die oben genannt sind miteinander kombiniert werden können, ohne dass es eines erfinderischen Schrittes bedarf.

## Detaillierte Beschreibung der Erfindung

Nachfolgend soll die Erfindung anhand eines Ausführungsbeispieles detailliert beschrieben werden.

Es zeigen:

Fig. 1          Eine EUV-Projektionsbelichtungsanlage mit einem Kollektor, umfassend wenigstens 2 Spiegelschalen, der eine Ebene in oder nahe eines facettierten optischen Elementes, ausleuchtet.

Fig. 2          die Ausleuchtung in oder nahe der Ebene, in der das facettierte optische Element angeordnet ist, bei Verwendung eines Kollektors gemäß dem Stand der Technik.

Fig. 3          eine im Wesentlichen quadratische Ausleuchtung in oder nahe der Ebene, in der das facettierte optische Element angeordnet ist.

Fig. 4a-4d      die Beeinflussung der Ausleuchtung in einer Ebene durch Deformation von geschlossenen Spiegelflächen.

Fig. 5a         einen Schnitt entlang der z-Achse in der y-z-Ebene durch eine Schale eines Kollektors, bei dem die Spiegelschale zur Erzielung einer im Wesentlichen quadratischen Ausleuchtung gezielt deformiert wurde.

Fig 5b          eine dreidimensionale Darstellung eines Systems mit zwei Flächen und zwei z-Achsen bezüglich derer die zwei Flächen definiert sind

Fig. 5c         eine dreidimensionale Darstellung eines Systems mit drei Flächen und zwei z-Achsen bezüglich derer die Flächen definiert sind, wobei zwei Flächen unstetig in z aneinander anschließen

Fig. 6.         eine Prinzipskizze eines Beleuchtungssystems zur Erzeugung einer im Wesentlichen quadratischen Ausleuchtung mit Hilfe eines asphärischen Spiegels.

Fig. 7.         eine Prinzipskizze zur Erzeugung einer im Wesentlichen quadratischen Ausleuchtung in einer Ebene mit Hilfe eines Gitterelementes mit optischer Wirkung.

| Fig. 8a-8c | Aufbau eines Kollektors gemäß dem Stand der Technik, wobei die einzelnen Ausleuchtungen in der Ebene im Wesentlichen aneinander anschließen. |
| Fig. 9a-9c | Aufbau eines Kollektors bei der die Ausleuchtung in der Ebene einen Abstand zueinander aufweisen, wobei die Feldwaben rechteckig ausgebildet sind. |
| Fig. 9d | Darstellung einer Feldwabenplatte, wobei die Feldwaben bogenförmig ausgebildet sind. |
| Fig. 10a-10b2 | Aufbau eines Kollektors aus Schalensegmenten zur Erzeugung einer im Wesentlichen rechteckigen Ausleuchtung in der Ebene. |
| Fig. 11a-11b | Aufbau eines Kollektors mit einem Segment zur Ausleuchtung unterschiedlicher Positionen in der Ebene. |
| Fig. 12a-12b | Unterschiedliche Beleuchtung aufgrund veränderter Zuordnung von Feld- und Pupillenfacetten. |
| Fig. 13a-13e | Unterschiedliche Beleuchtungen des facettierten optischen Elementes mit Feldfacetten und hieraus resultierende unterschiedliche Pupillenausleuchtung mit Hilfe eines optischen Einstellelementes |

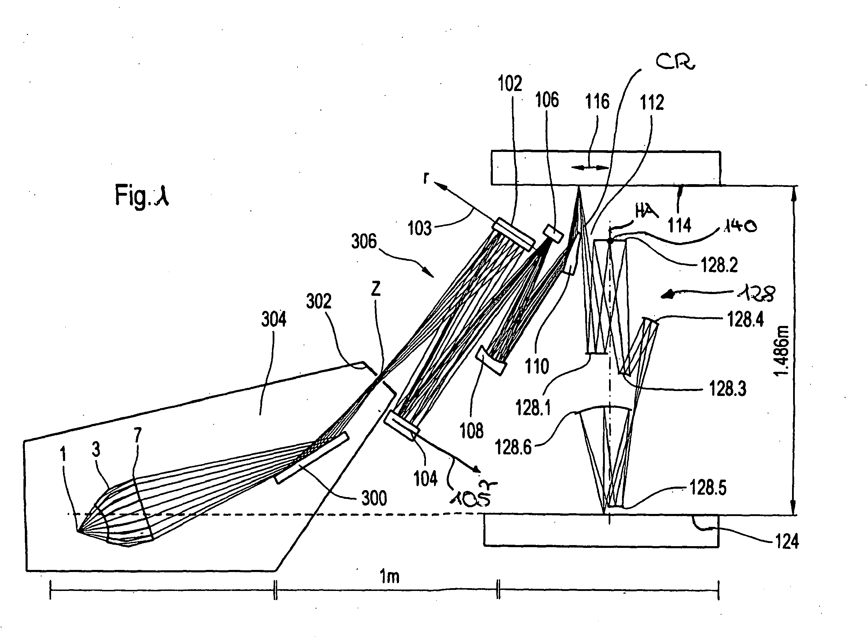

In Figur 1 ist in einer Prinzipansicht eine Projektionsbelichtungsanlage für die Herstellung von beispielsweise mikroelektronischen Bauteilen, bei der die Erfindung zur Anwendung kommen kann, gezeigt. Die Projektionsbelichtungsanlage umfasst eine Lichtquelle oder ein Zwischenbild einer Lichtquelle 1. Das von der Lichtquelle 1 ausgesandte Licht wird von einem Kollektor 3 umfassend eine Vielzahl von Spiegelschalen gesammelt. Auf den Kollektor folgt bei der gezeigten Projektionsbelichtungsanlage ein weiteres optisches Element, das vorliegend als Planspiegel 300 ausgebildet ist. Die vom Kollektor auf den Planspiegel auftreffenden Strahlen werden umgelenkt, insbesondere um Bauraum für die mechanischen und optischen Komponenten in einer Objektebene 114, in der die Waferstage angeordnet ist, zur Verfügung zu stellen. Die Objektebene 114 wird auch als Feldebene bezeichnet. Der Planspiegel 300 kann auch als diffraktives Spektralfilterelement ausgelegt werden. Ein derartig diffraktives Spektralfilterelement ist beispielsweise ein Gitter, wie in der US-2002-0186811 A1 offenbart. Zusammen mit der Blende 302 in der Nähe des Zwischenbildes Z der Lichtquelle 1 kann mit einem derartigen Gitterelement ungewünschte Strahlung mit beispielsweise Wellenlängen wesentlich größer als der gewünschte Wellenlänge vom Eintritt in den Teil des hinter der Blende 302 liegenden Beleuchtungssystems abgehalten werden. Insbesondere kann Strahlung mit Wellenlängen ungleich der Nutzwellenlänge von beispielsweise 13,5 bei EUV-Mikrolithographie-Projektionsbelichtungsanlagen vom Eintritt in das hinter der Blende 302 liegende optische System abgehalten werden.

Die Blende 302 kann auch dazu dienen, den Raum 304 umfassend die Lichtquelle sowie den Kollektor 3 und den als Gitter ausgelegten Planspiegel 300 vom nachfolgenden Beleuchtungssystem das Einbringen eines Ventils nahe des Zwischenfokus Z getrennt, so ist auch eine 306 räumlich zu trennen. Werden beide Räume durch druckmäßige Trennung möglich. Durch eine räumliche bzw. eine druckliche Trennung kann verhindert werden, dass Verschmutzungen, die von der Lichtquelle 1 herrühren, in das hinter der Blende 302 liegende Beleuchtungssystem gelangen.

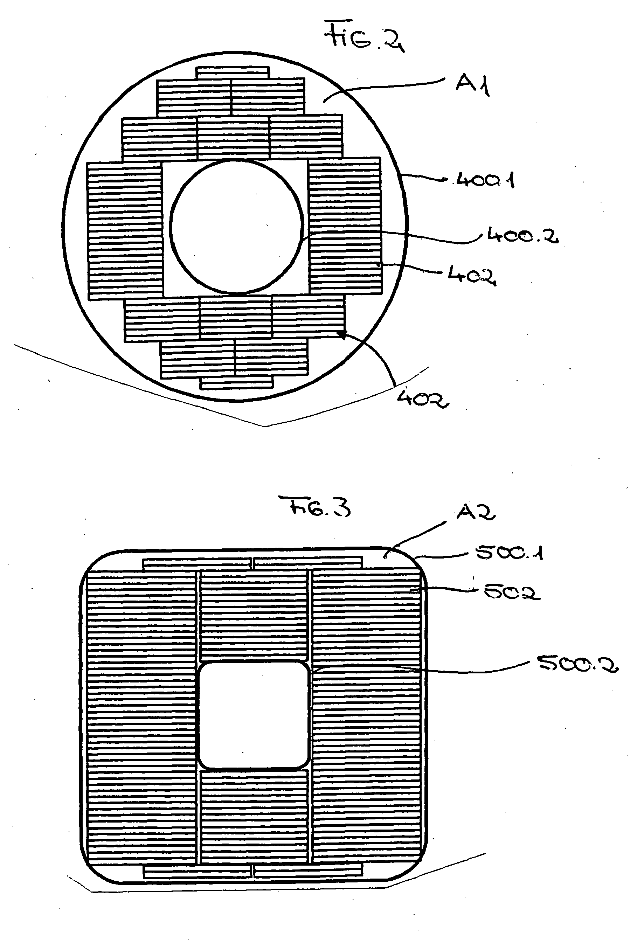

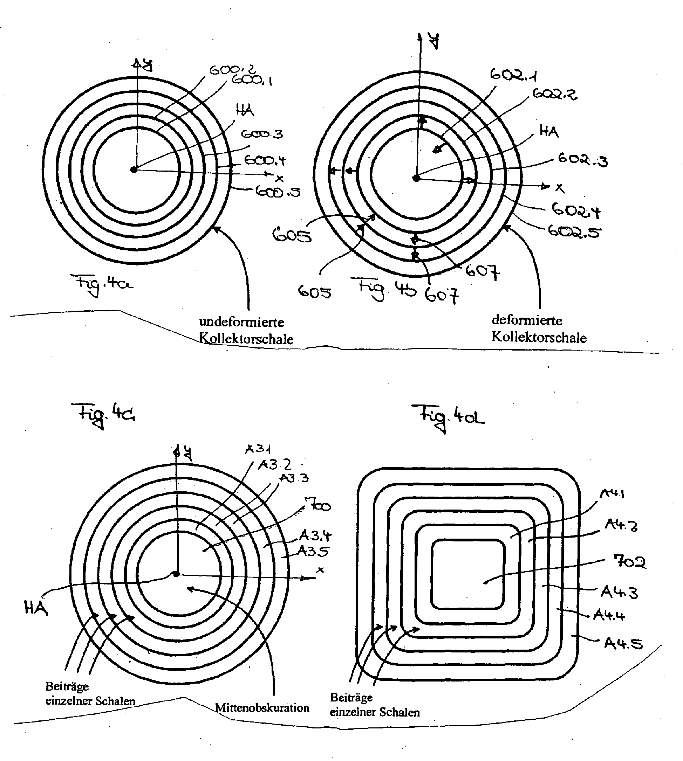

Das von dem Kollektor 3 gesammelte und über den Planspiegel 300 umgelenkte Licht wird auf einen Spiegel 102 mit einer Vielzahl von ersten Rasterelementen, sog. Feldfacetten oder Feldrasterelemente, gelenkt. Im vorliegenden Fall sind die ersten Rasterelemente plan ausgebildet. Die Ausleuchtung in der Ebene 103 in oder nahe des facettierten Spiegels 102 angeordnet ist, kann, wie im Stand der Technik gemäß Figur 2 dargestellt, im Wesentlichen kreisförmig sein, wobei durch jede Spiegelschale des Kollektors je ein kreisringförmiger Bereich ausgeleuchtet wird, welcher in der Ebene 103 im Wesentlichen direkt an benachbarte kreisringförmige Bereiche anschließt. Eine derartige Ausleuchtung für einen Kollektor gemäß dem Stand der Technik wie in der US-2003-0043455A1 beschrieben, ist in Figur 2 gezeigt. Alternativ kann gemäß der Erfindung ein Kollektor vorgesehen sein, der nicht rotationssymmetrische, beispielsweise deformierte Spiegelschalen aufweist, so dass eine nicht rotationssymmetrische, beispielsweise eine im Wesentlichen rechteckige Ausleuchtung in der Ebene, in der das erste optische Element 102 mit Feldrasterelementen angeordnet ist, erzielt wird. Eine derartige Ausleuchtung ist beispielsweise in Figur 3 oder Figur 4d gezeigt. Ein Kollektor mit deformierten Spiegelschalen zeigt z. B. Figur 4b.

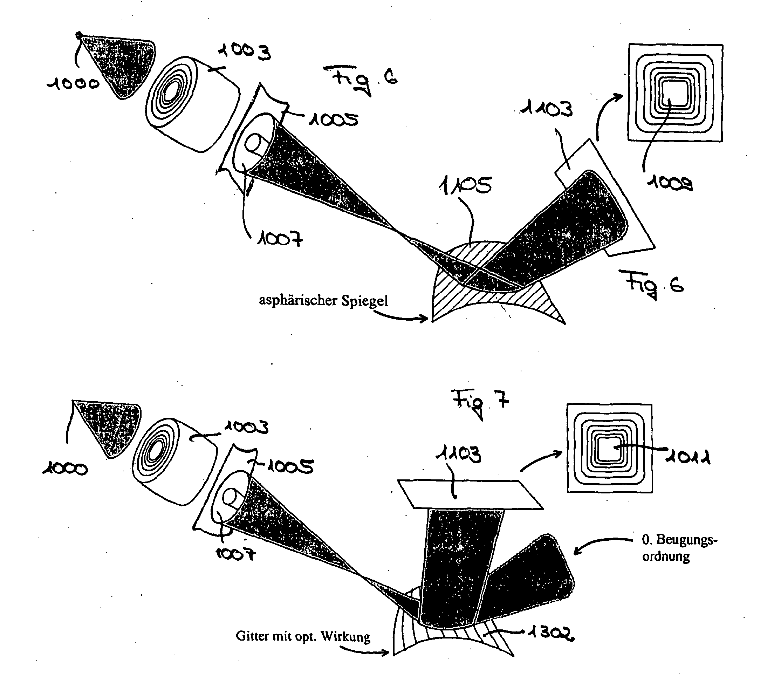

Alternativ zu einem Kollektor mit nicht rotationssymmetrischen Spiegelschalen kann zur Erzeugung der im Wesentlichen rechteckigen Ausleuchtung auch ein Kollektor mit rotationssymmetrischen Spiegelschalen vorgesehen sein, wobei ein optisches Element, wie beispielsweise das optische Element 300, das dem Kollektor im Lichtweg nachgeordnet ist, die Formung der Ausleuchtung wie in den Figuren 6 und 7 beschrieben, übernimmt. Hierzu wird beispielsweise der Spiegel 300 asphärisch ausgebildet, wie in Figur 6 gezeigt.

Das Beleuchtungssystem ist ein doppelt facettiertes Beleuchtungssystem, wie beispielsweise in der US 6,198,793 B1 offenbart, und umfasst ein erstes optisches Element 102 mit Feldrasterelementen und ein zweites optisches Element 104 mit Pupillenrasterelementen. Das zweite optische Element 104 mit Pupillenrasterelementen (nicht gezeigt) ist in oder nahe einer weiteren Ebene angeordnet, die auch als Pupillenebene 105 bezeichnet wird.

Das von der Lichtquelle her einfallende Licht wird durch das facettierte optische Element 102 mit Feldrasterelementen in mehrere Lichtbündel zerlegt, wobei jedem Feldrasterelement genau ein Pupillenrasterelement des zweiten optischen Elements zugeordnet ist. Diese Zuordnung bestimmt, wie in der US 2002-0136351 A1 gezeigt, die Ausleuchtung in der Austrittspupille des Beleuchtungssystems. Die Austrittspupille des Beleuchtungssystems ist im Regelfall durch den Schnittpunkt des Hauptstrahls (CR) zum zentralen Feldpunkt im auszuleuchtenden Feld in der Objektebene 114 mit der optischen Achse HA des Projektionsobjektives gegeben. Diese Austrittspupille ist im vorliegenden Ausführungsbeispiel mit der Bezugsziffer 140 gekennzeichnet. Die optischen Elemente 106, 108, 110 dienen im Wesentlichen dazu, das Feld in der Objektebene 114 zu formen. Das Feld in der Objektebene 114 ist im Regelfall ein Kreisbogensegment. In der Objektebene 114 ist ein nicht dargestelltes Retikel angeordnet, das mit Hilfe der Beleuchtungsvorrichtung 306 ausgeleuchtet und mit Hilfe des Projektionsobjektives 128 in eine Bildebene 124 abgebildet wird. In einem Scanning-System ist das in der Objektebene 114 angeordnete Retikel in Richtung 116 verfahrbar. Die Austrittspupille des Beleuchtungssystems fällt mit der Eintrittspupille des Projektionsobjektives 128 zusammen.

In einer alternativen, nicht dargestellten Ausführungsform der Erfindung können die Feldrasterelemente bzw. Feldfacetten die Form des auszuleuchtenden Feldes in der Objektebene aufweisen und damit die Form des Feldes in der Objektebene bestimmen. Ein derartiges Beleuchtungssystem ist beispielsweise aus der US 6,195,201 bekannt geworden. Ist die Form des Feldes in der Objektebene beispielsweise kreisbogenförmig, so sind die Facetten ebenfalls bogenförmig ausgebildet.

Wie in Figur 1 dargestellt sind die Mikrolithographie-Projektionsbelichtungsanlagen für eine Verwendung im Gebiet der EUV-Lithographie mit einer Nutzwellenlänge von beispielsweise 13,5 nm vollständig reflektiv ausgeführt, d.h. die Feldrasterelemente sind als Feldfacettenspiegel ausgebildet und die Pupillenrasterelemente als Pupillenfacettenspiegel.

Durch die nicht rotationssymmetrische Ausleuchtung in der Ebene, in der die Feldrasterelemente angeordnet sind, beispielsweise die im Wesentlichen rechteckige Ausleuchtung werden die Lichtquellenbilder nicht objekttreu sondern verzeichnet in eine Pupillenebene, beispielsweise die Austrittspupille abgebildet. Dies kann kompensiert werden durch asphärische Feldrasterelemente (nicht dargestellt). Unterschiedliche Feldrasterelemente des ersten optischen Elementes weisen dann bevorzugt unterschiedliche Asphärizitäten auf; je nachdem welche Asphärizität benötigt wird, um die durch die Ausleuchtung hervorgerufene Verzeichnung in der Abbildung des Lichtquellenbildes zu kompensieren.

Das Projektionsobjektiv 128 weist in der dargestellten Ausführungsform sechs Spiegel 128.1, 128.2, 128.3, 128.4, 128.5 sowie 128.6 auf und ist beispielsweise wie im US-Patent US 6,600,552 B2 ausgebildet.

Das Projektionsobjektiv 128 bildet das in der Objektebene 114 befindliche, nicht dargestellte Retikel in die Bildebene 124 ab.

In Figur 2 ist die Ausleuchtungsverteilung in der Ebene 103 des ersten optischen Elementes 102 aus Figur 1 dargestellt. Der insgesamt durch den Kollektor ausgeleuchtete Bereich A1 ist durch ein von der äußersten Spiegelschale herrührende Begrenzung 400.1 und eine von dem innersten Aperturelement herrührende innere Begrenzung 400.2 definiert.

Deutlich zu erkennen ist, dass bei im Wesentlichen rotationssymmetrischen Spiegelschalen die Ausleuchtung in der Ebene 103 in Figur 1 kreisförmig ist. Des Weiteren zu erkennen sind die Feldfacetten 402 des ersten facettierten optischen Elementes 102 in Figur 1. Die einzelnen Feldfacetten 402 sind Spiegelelemente, die auf einem Träger angeordnet sind. Die Feldfacetten 402 weisen im dargestellten Ausführungsbeispiel eine im Wesentlichen rechteckige Form auf. Prinzipiell sind auch Feldfacetten mit einer anderen Gestalt, beispielsweise einer bogenförmige Gestalt möglich, wie oben beschrieben.

Wie aus Figur 2 hervorgeht, beträgt der geometrische Lichtverlust des ausgeleuchteten Bereiches im Vergleich zur Fläche, in der die Feldfacetten angeordnet sind, ungefähr 40%.

Zur Reduzierung des geometrischen Lichtverlustes ist erfindungsgemäß vorgesehen, die Ausleuchtung in der Ebene 103 gemäß Figur 1 an die rechteckige Form der Feldfacetten 502 anzupassen. Eine derartig optimierte Ausleuchtung in der Feldebene 103 gemäß Figur 1 ist in Figur 3 dargestellt. Die im Wesentlichen rechteckige Ausleuchtung A2 in der Ebene 103 in Figur 1 weist wiederum eine äußere Begrenzung 500.1 und eine innere Begrenzung 500.2 auf. Die Feldfacetten in Figur 3 sind mit der Bezugsziffer 502 bezeichnet.

Durch eine, wie in Figur 3, dargestellte im Wesentlichen rechteckige, insbesondere nahezu quadratische Ausleuchtung in der Ebene 103 wird der geometrische Lichtverlust, d.h. der Anteil des Lichtes, der nicht von den Feldfacetten aufgenommen wird, auf weniger als 10 % reduziert, falls die Feldfacetten wie dargestellt rechteckig ausgebildet sind.

Eine im Wesentlichen rechteckige Ausleuchtung in der Ebene 103 lässt sich auf unterschiedlichste Art und Weise erreichen. In einer ersten Ausgestaltung, wie in den Figuren 4a bis 4d angegeben, weist der Kollektor 3 gemäß Figur 1 geschlossene Spiegelflächen auf, die um eine Rotationsachse ineinander angeordnet sind.

Durch eine gezielte astigmatische Deformation der einzelnen Kollektorschalen ist es möglich, eine derartige im Wesentlichen rechteckige Ausleuchtung zu erreichen. In Figur 4b ist die nach innen, d. h. zur optischen Achse HA hin gerichtete Deformation der einzelnen Kollektorschalen 602.1, 602.2, 602.3, 602.4, 602.5 mit 605 bezeichnet und die nach außen gerichtete, d. h. von der optischen Achse HA weg gerichtete Deformation mit 607. Die Pfeile 605 und 607 stehen senkrecht auf der deformierten Kollektorfläche. Dies ist nachfolgend erläutert.

In Figur 4c ist für einen Kollektor mit einer Vielzahl von undeformierten, um eine gemeinsame Rotationsachse HA rotationssymmetrischen Spiegelschalen 600.1, 600.2, 600.3, 600.4, 600.5, die Ausleuchtung in der Ebene 103 dargestellt. Die gemeinsame Rotationsachse ist auch Symmetrieachse. Die in Figur 4c dargestellte Ausleuchtung in der Ebene 103 in Figur 1 zeichnet sich durch eine Mittenobskuration 700 und Ausleuchtungen A3.1, A3.2, A3.3, A3.4, A3.5, die den jeweiligen Spiegelschalen 600.1, 600.2, 600.3, 600.4 sowie 600.5 des in Figur 4a dargestellten Kollektors mit im Wesentlichen um die Achse HA rotationssymmetrischen Spiegelschalen zugeordnet sind, aus. Die Ausleuchtungen A3.1, A3.2, A3.3, A3.4, A3.5 sind wiederum kreisförmig und schließen im Wesentlichen mit einer kleinen Lücke direkt aneinander an. In der Ebene 103, in der die Feldfacetten des ersten optischen Elementes angeordnet sind, wird dann eine Ausleuchtung wie in Figur 2 dargestellt, erreicht.

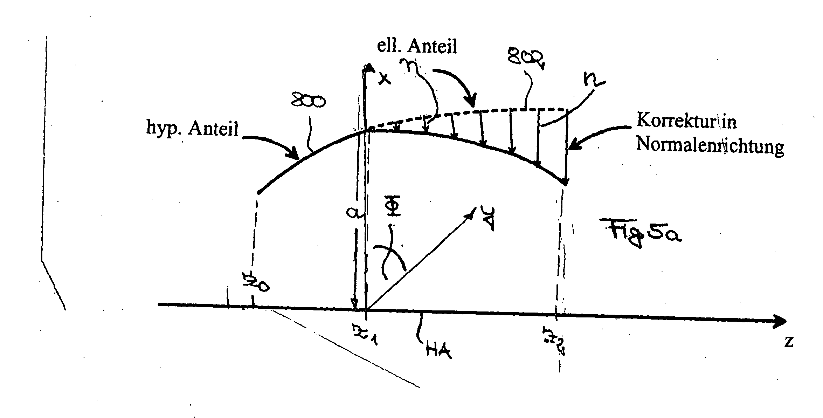

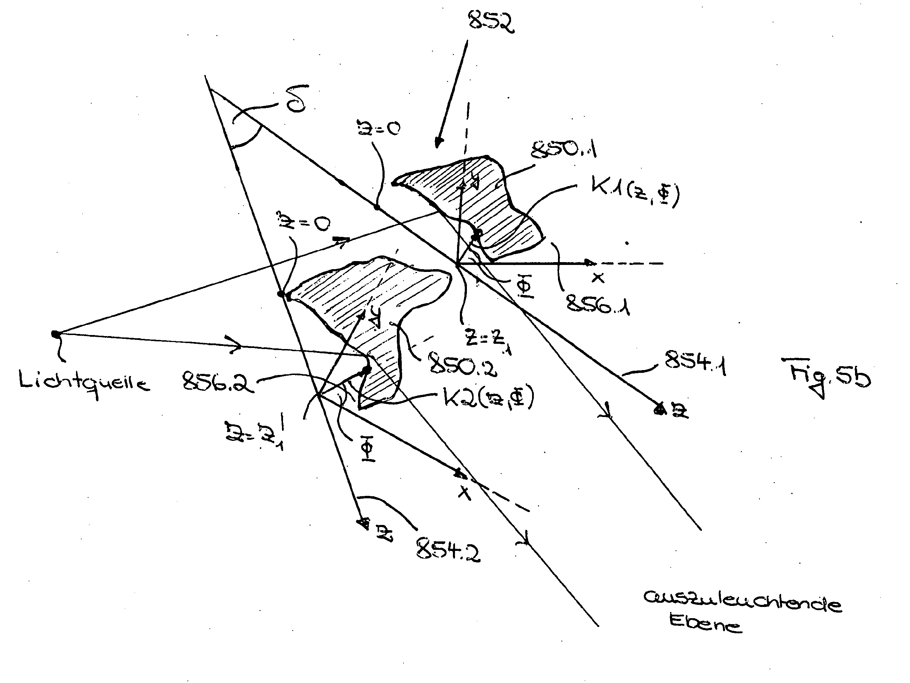

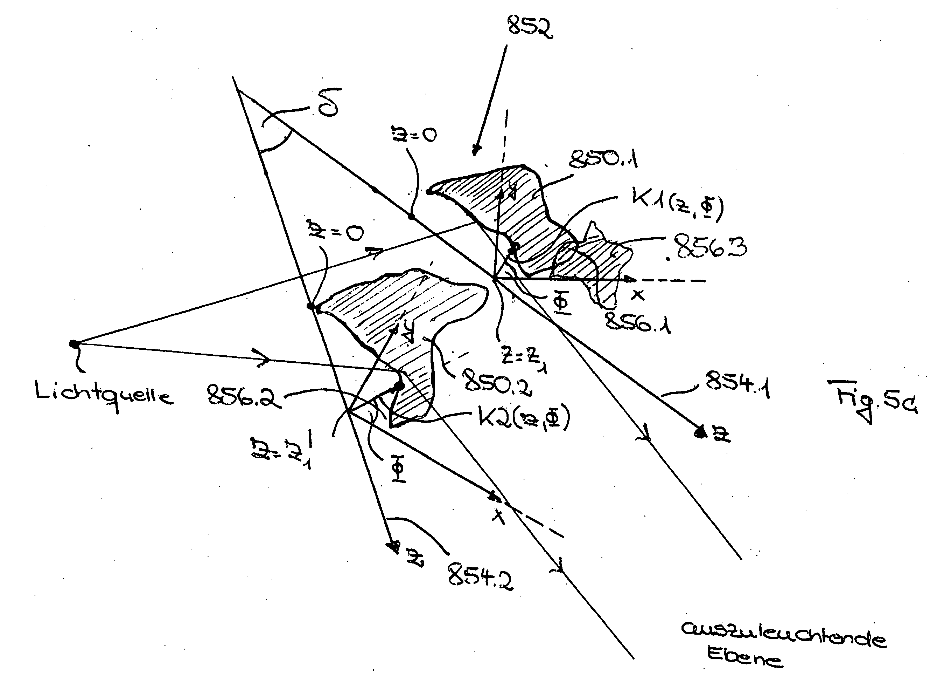

Werden die einzelnen Schalen 602.1, 602.2, 602.3, 602.4 sowie 602.5, wie in Figur 4b und nachfolgend näher beschrieben, deformiert, so ergibt sich eine Ausleuchtung wie in Figur 4d dargestellt in der Ebene 103 gemäß Figur 1. Die Ausleuchtung, wie in Figur 4d dargestellt, ist im Wesentlichen rechteckförmig und weist eine Mittenobskuration 702 auf sowie den jeweiligen deformierten Spiegelschalen gemäß Figur 4b zugeordnete Ausleuchtungen A4.1, A4.2, A4.3, A4.4 sowie A4.5. Eine quadratische Ausleuchtung, wie in Figur 4d dargestellt, aufgrund der Deformation von geschlossenen Spiegelflächen kann beispielsweise durch nachfolgend beschriebene Auslegung einer Kollektorschale erreicht werden. Bezug wird hierbei auf Figur 5a genommen. Die Spiegelschale gemäß Figur 5a ist im Schnitt entlang der Achse HA dargestellt. Die Kollektorschale setzt sich zusammen aus einem um die optische Achse HA rotationssymmetrischen Grundkörper aus einem ersten hyperbolischen Spiegelsegment sowie einem an das hyperbolische Spiegelsegment anschließende elliptische Spiegelsegment. Das hyperbolische erste Spiegelsegment 800 wird durch Rotation eines Hyperboloides um die optische Achse HA erhalten. Das zweite rotationssymmetrische elliptische Spiegelsegment ist in Figur 5 strichpunktiert dargestellt und mit Bezugsziffer 802 versehen. Das rotationssymmetrische elliptische Spiegelsegment wird wiederum durch Rotation um die Achse HA erhalten.

Die beiden Anteile des rotationssymmetrischen Grundkörpers, nämlich der erste hyperbolische Anteil 800 sowie der zweite elliptische Anteil 802, werden durch nachfolgende Funktion beschrieben.

$$z(h, k, \rho, z_0) = \frac{\rho h^2}{1 + \sqrt{1 - (1+k)(h\rho)^2}} + z_0 \, ,$$

wobei $k$ die konische Konstante und $\rho$ die Krümmung am Scheitel beschreiben. Diese Parameter sowie die z-Begrenzuhgen $z_1$ und $z_2$ der Flächen sind in folgender Tabelle 1 angegeben.

Tabelle 1 - Daten für eine rotationssymmetrische Spiegelschale

|  | $k$ | $\rho \ [mm^{-1}]$ | $z_0 \ [mm]$ | $z_1 \ [mm]$ | $z_2 \ [mm]$ |
|---|---|---|---|---|---|
| Hyperboloid | -1.26602359 | 0.04479337 | -10.505 | 78.374 | 159.801 |
| Ellipsoid | -0.96875135 | 0.03730042 | -202.361 | 159.801 | 275.000 |

Die in obiger Tabelle1 dargestellte Kollektorschale erzeugt im Fernfeld eine ringförmige Ausleuchtung wie in Figur 4c gezeigt.

Zur quadratischen Fernfeldausleuchtung gelangt man durch eine gezielte Abweichung des elliptischen Anteils von der Rotationssymmetrie, welche durch eine Korrektur in Normalenrichtung des Grundkörpers beschrieben werden kann. In dieser Anmeldung beschreibt die Normalenrichtung die Richtung, die jeweils senkrecht auf der Spiegelschale am Ort z steht. Ein solcher Normalenvektor n ist für verschiedene Positionen z in Figur 5a dargestellt.

Des Weiteren in Figur 5a gezeigt ist das x-y-z-Koordinatensystem sowie das Zylinderkoordinatensystem r, Φ in welchem die Abweichung von der Rotationssymmetrie, mit der die im Wesentlichen rechteckige Ausleuchtung in der Ebene 103 erreicht werden kann, beschrieben ist. Der nicht rotationssymmetrische Anteil bzw. die Korrektur des elliptischen Anteils wird in Zylinderkoordinaten durch die nachfolgende Funktion beschrieben:

$$f(z,\phi,a) = a\,\frac{z - z_1}{z_2 - z_1}\,\sin(4(\phi - \tfrac{\pi}{8})),$$

wobei der Normalenvektor n an jedem Punkt des rotationssymmetrischen Grundkörpers dargestellt ist. Des weiteren bezeichnet $\phi$ den Azimuthwinkel in einer Ebene, die senkrecht auf der z-Achse steht, wobei die z-Achse Rotationsachse für die Rotationskörper ist.. Die Größe f(z,$\phi$,a), die das Maß der Korrektur darstellt, steigt bei dem gezeigten Ausführungsbeispiel linear mit z an und erreicht ihr Maximum am Kollektorende. Die Größe a ist vorliegend eine Konstante. Figur 4d zeigt die Ausleuchtung in der Ebene 103 in Figur 1 schematisch.

Alternativ kann der nicht rotationssymmetrische Anteil zu dem ersten hyperbolischen Spiegelsegment 800 (nicht gezeigt) oder zu beiden Spiegelsegmenten hinzuaddiert oder abgezogen werden.

Als weitere Alternative kann ein Spiegel mehrstückig ausgebildet sein, wobei der Spiegel abschnittsweise rotationssymmetrische Segmente und abschnittsweise nicht rotationssymmetrische Segmente wie oben beschrieben aufweist. Die Segment können stetig oder unstetig aneinander anschließen. Im ersten Fall wird beispielsweise ein einstückiger Spiegel ausgebildet und in dem zweiten Fall ein mehrstückiger Spiegel.

Alternativ zu oben genannter Ausführungsform kann ein Kollektor 852 wie in Figur 5b gezeigt mit wenigstens einer deformierten Spiegelfläche zur Erzeugung von beliebigen Ausleuchtungen umfassend zwei Flächen 850.1, 850.2 wie nachfolgenden beschrieben erhalten werden.

Jede der beiden Flächen 850.1, 850.2 des Kollektors ist durch eine Achse 854.1, 854.2 definiert und eine Flächenfunktion in Bezug auf die jeweilige Achse. Als Achse wird vorliegend für jede Fläche eine z-Achse 854.1, 854.2 angesehen. Auf jeder z-Achse 854.1, 854.2 senkrecht steht eine x-y, Ebene 856.1, 856.2 für jede Fläche, die in Polarkoordinaten durch einen Radius r und einen Azimutwinkel $\phi$ definiert werden kann. Ganz allgemein ist die Flächenfunktion K1, K2 jeder Fläche 850.1, 850.2 eine Funktion ihrer jeweiligen z-Koordinate und ihrer jeweiligen Azimutwinkel $\Phi$, wobei der Azimutwinkel zwischen 0 und $2\pi$ variieren können. Werden geschlossene Flächen beschrieben, so nimmt der Azimutwinkel $\Phi$ Werte von 0 bis $2\pi$ an. Wird lediglich ein Spiegelsegment und keine geschlossene Spiegelfläche beschrieben, wie hier gezeigt, so nimmt der Azimutwinkel $\Phi$ Werte zwischen 0 und $2\pi$, beispielsweise von $\pi/2$ bis $\pi$ an. Somit kann eine Fläche in Ihrer allgemeinsten Form durch eine von z und dem Azimutwinkel $\phi$ abhängige Krümmung K(z,$\Phi$) beschrieben werden. Vorliegend ergibt sich eine Flächenfunktion K1 (z,$\Phi$) für die erste Fläche 850.1 und K2(z, $\Phi$) für die zweite Fläche 850.2.

Selbstverständlich sind auch Kollektoren denkbar, die mehr als zwei Flächen, beispielsweise drei oder vier Flächen umfassen.

Auch können wie in Figur 5c gezeigt durch Kombination der Flächen wie in Figur 5b gezeigt mit dem Merkmal der Unstetigkeit der Spiegelflächen Kollektoren erzeugt werden, die zwei unstetig in z-Richtung aneinander anschließende Flächen 850.1, 850.3 umfassen, die bezüglich einer z-Achse, hier der z-Achse 854.1 definiert sind. Neben der mehrstückigen Fläche die aus den zwei unstetig aneinander anschließenden Flächen 850.1, 850.3 besteht; kann der Kollektor auch noch die einstückige Fläche 850.2 umfassen. Gleiche Bezugsziffern wie in Figur 5b werden auch in Figur 5c verwandt.

Jeder der wenigstens zwei benachbarten Flächen ist in dem gezeigten Ausführungsbeispiel je eine lokale z-Achse zugeordnet. So ist der ersten Fläche eine erste z-Achse 860.1 und der zweiten Fläche eine zweite z-Achse 860.2 zugeordnet. Vorliegend schließen die erste und die zweite z-Achse 860.1, 860.2 einen Winkel $\delta$ miteinander ein.

Alternativ zu der gezielten Deformation der Kollektorschalen zum Erzielen der im Wesentlichen rechteckigen, bevorzugt quadratischen Ausleuchtung in der Ebene 103, in der das erste facettierte optische Element angeordnet ist, kann, wie in Figur 6 gezeigt, im Lichtweg von der Lichtquelle 1000 zur Ebene 1103 nahe des facettierten optischen Elementes ein asphärischer Spiegel 1105 angeordnet sein. Der asphärische Spiegel 1300 transformiert eine von dem Kollektor 1003 mit einer Vielzahl von Spiegelschalen in eine Ebene 1005 erzeugte im Wesentlichen ringförmige Ausleuchtung 1007 in eine im Wesentlichen rechteckige Ausleuchtung 1009, die in der Ebene 1103 vorliegt.

Bei einem Projektionssystem, wie in Figur 1, kann dies beispielsweise dadurch erreicht werden, dass der Spiegel 300 als asphärischer Spiegel ausgelegt ist.

In Figur 7 ist eine alternative Ausführungsform der Erfindung gezeigt, bei der eine im Wesentlichen ringförmige Ausleuchtung 1007 in einer Ebene 1005 direkt neben dem Kollektor 1003 mit Hilfe eines Gitters 1302 mit optischer Wirkung in eine im Wesentlichen rechteckige, bevorzugt quadratische Ausleuchtung 1011 in einer Ebene 1103, in der das erste optische Element mit Feldrasterelementen zum Liegen kommt, transformiert wird. Durch das Gitterelement 1302 wird das Licht in die erste Beugungsordnung gebeugt. Das Licht der nullten Beugungsordnung, das auch Wellenlängenanteile enthält; die nicht der Nutzwellenlänge entsprechen, kann durch eine Blende daran gehindert werden, in das Beleuchtungssystem einzutreten. Die Nutzwellenlänge ist die Wellenlänge die zur Abbildung eines Objektes in eine Objektebene in ein Bild in einer Bildebene in einer Mikrolithographie-Projektionsbelichtungsanlage genutzt wird. Eine Nutzwellenlänge in der EUV-Lithographie wäre eine Wellenlänge von 13.5 nm.

Bei dem Ausführungsbeispiel gemäß Figur 7 sind gleiche Bauteile wie in Figur 6 mit denselben Bezugsziffern belegt. Um den in Figur 7 dargestellten Effekt zu erzielen, kann bei einem Beleuchtungssystem gemäß Figur 1 vorgesehen sein, den Spiegel 300 als Gitter mit optischer Wirkung auszulegen.

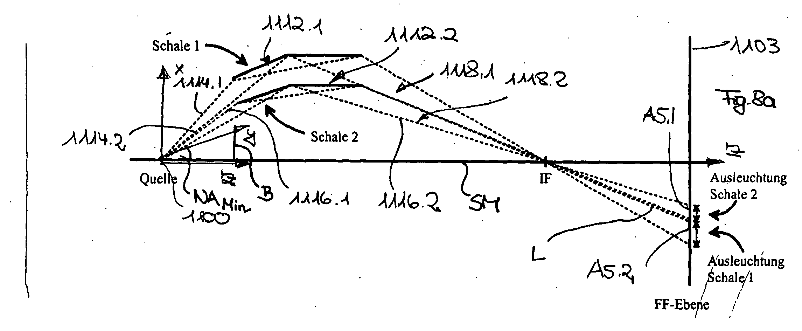

Ein weiteres Problem bei Kollektoren, wie sie derzeit im Stand der Technik angewendet werden, ist darin zu sehen, dass die Ausleuchtung der einzelnen Spiegelschalen im Wesentlichen direkt aneinander anschließen. Für zwei Schalen ist in Figur 8a ein derartiger Kollektor wie in der US 2003-0043455A1 beschrieben im Schnitt durch die x-z-Ebene dargestellt. Die Quelle ist mit der Bezugsziffer 1100 gekennzeichnet, die erste Schale mit Bezugsziffer 1112.1 und die zweite Schale mit Bezugsziffer 1112.2. Des Weiteren sind die Randstrahlen 1114.1, 1114.2, 1116.1, 1116.2 des ersten Strahlbüschels 1118.1, das von der ersten Kollektorschale 1112.1 aufgenommen wird, und des zweiten Strahlbüschels 1118.2, das von der zweiten Kollektorschale 1112.2 aufgenommen wird, eingezeichnet. Der Randstrahl 1116. 2 der zweiten Spiegelschale 1112.2, der am nächsten zur Symmetrieachse SM um den die geschlossenen Schalen rotationssymmetrisch sind, angeordnet ist, bestimmt die minimale Kollektionsapertur $NA_{Min}$ die vom in Figur 8a dargestellten Kollektor von der Lichtquelle 1100 noch aufgenommen werden kann. Licht mit noch kleineren. Winkel kann von dem Kollektor nicht aufgenommen werden. Um den Durchtritt von Streulicht durch den Kollektor zu verhindern, ist im Inneren der zweiten Spiegelschale 1112.2, die am nächsten zur Symmetrieachse ist, eine Blende B angeordnet. Die beiden Strahlbüschel 1118.1, 1118.2 werden an den Schalen 1112.1, 1112.2 reflektiert und leuchten in der Ebene 1103, die im Wesentlichen der in Figur 1 dargestellten Ebene 103 entspricht, die Bereiche A5.1 und A5.2 aus.

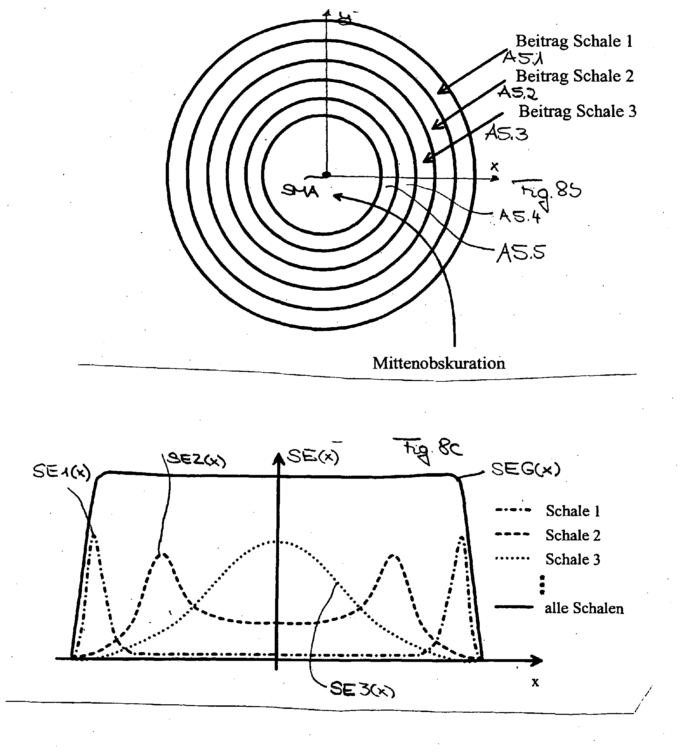

Wie deutlich aus dem x-z-Schnitt in Figur 8a zu entnehmen, schließen die beiden Ausleuchtungen in der Ebene 1103 im Wesentlichen direkt aneinander an. Die zwischen den Ausleuchtungen bestehende kleine Lücke, die kleiner als 1 mm ist, wird alleine durch die endliche Dicke der einzelnen Reflektorschalen bedingt, d.h. der Abstand von erster und zweiter Ausleuchtung in der Ebene 1103 beträgt weniger als 1 mm. Die Ausleuchtung in der Ebene 1103 in x-y-Richtung für ein System gemäß Figur 8a ist in Figur 8b dargestellt.

Deutlich zu erkennen sind in Figur 8b die einzelnen Ringsegmente A5.1, A5.2, A5.3, A5.4, A5.5. Diese einzelnen Ringsegmente schließen in der Ebene 1103 im Wesentlichen direkt aneinander an. In Figur 8b ist auch die Symmetrieachse der Ausleuchtung SMA gezeigt.

Bei der Figur 8a ist lediglich die erste und zweite Spiegelschale gezeigt, wohingegen Figur 8b auch noch die Ausleuchtung der weiteren Spiegelschalen, nämlich der 3., 4. und 5. Schale, darstellt.

In Figur 8c ist für die 1., 2. und 3. Schale die über den Scan-Weg, d.h. in y-Richtung integrierte Energie SE (x) für die erste Schale mit der Ausleuchtung A5.1, für die zweite Schale mit der Ausleuchtung A5.2 und für die dritte Schale mit der Ausleuchtung A5.3 gezeigt. Die scan-integrierte Energie für die erste Schale ist mit der Bezugsziffer SE1, die für die zweite Schale mit der Bezugsziffer SE2 und die für die dritte Schale mit der Bezugsziffer SE3 bezeichnet. Die scan-integrierte Energie ergibt sich wie oben dargestellt durch Integration der Beiträge der einzelnen Spiegelschalen entlang der y-Achse des auszuleuchtenden Ringfeldes der Feldebene 114. In Figur 1 ist das lokale Koordinatensystem in der Feldebene angegeben. Wie aus Figur 1 zu entnehmen ist, ist die y-Richtung; die auch die Integrationsrichtung ist, die Scan-Richtung für die in Figur 1 gezeigte Ringfeld-Projektionsbelichtungsanlage, die im Scanning-Modus betrieben wird.

Aus der Figur 8c geht hervor, dass zwar die summierte scan-integrierte Energie SE(x) einen weitgehend homogenen Verlauf aufweist, nicht jedoch die Beiträge der einzelnen Spiegelschalen.

Dies führt dazu, dass bei thermischer Deformation einzelner Spiegelschalen oder bei einer Änderung der Reflektivität einer einzelnen Spiegelschale die scan-integrierte Uniformität sehr stark schwankt. Um dieses Problem zu lösen, schlägt die Erfindung gemäß einem weiteren Aspekt vor, dass zwischen dem durch die erste Schale ausgeleuchteten Bereich und den durch die zweite Schale ausgeleuchteten Bereich ein unausgeleuchteter Bereich vorgesehen ist, d.h. die erste Ausleuchtung beabstandet zur zweiten Ausleuchtung ist, so dass auch bei thermischer Deformation der jeweiligen Spiegelschalen die Ausleuchtungen nicht überlappen. Auf diese Art und Weise kann eine weitgehend homogene scan-integrierte Uniformität sichergestellt werden.

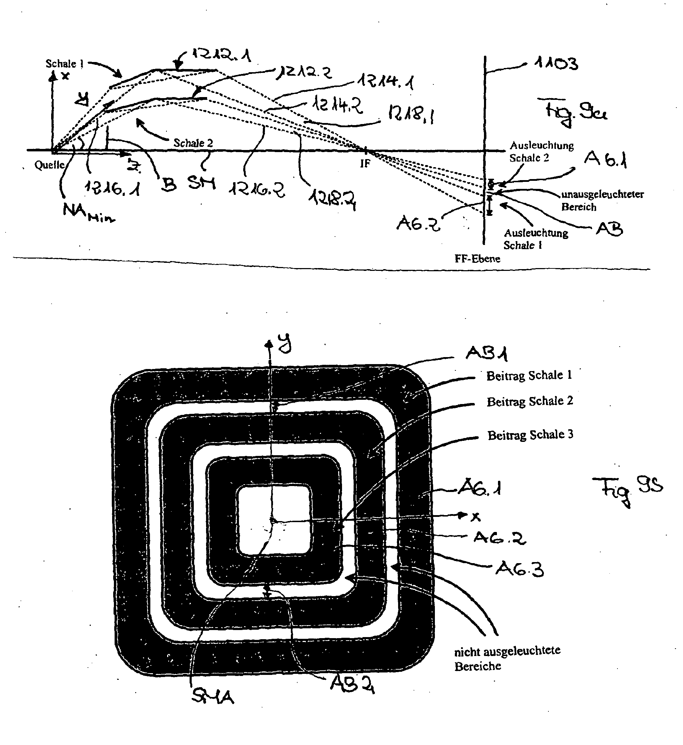

In Figur 9a ist wiederum im x-z-Schnitt ein System gezeigt, bei dem zwischen dem ausgeleuchteten Bereich A6.1 und dem ausgeleuchteten Bereich A6.2 der ersten Spiegelschale 1212.1 bzw. der zweiten Spiegelschale 1212.2 ein Abstand AB vorliegt. Gleiche Bauteile wie in Figur 8a tragen Bezugsziffern, die um 100 erhöht sind. Bevorzugt handelt es sich bei den Schalen 1212.1, 1212.2 um deformierte Kollektorschalen, die in der Ebene 1102 nicht nur zu einem Abstand zwischen den ausgeleuchteten Bereichen führen, sondern auch zu einer im Wesentlichen rechteckigen Form der Ausleuchtung, wie in Figur 9b dargestellt. Wiederum angegeben ist die minimale Kollektionsapertur $NA_{Min}$ die von der innersten Kollektorschale, hier der zweiten Kollektorschale 1212.2 noch aufgenommen wird. Des weiteren ist die Blende B gezeigt, die den Durchtritt von Streulicht verhindert. Des weiteren eingezeichnet ist die z-Achse, die gleichzeitig in den vorliegendem Ausführungsbeispiel auch gemeinsame Symmetrieachse für die geschlossenen, nicht rotationssymmetrischen Spiegelschalen ist.

In Figur 9b ist die Ausleuchtung für insgesamt 3 Spiegelschalen gezeigt, nämlich eine erste Schale, eine zweite Schale sowie eine dritte Schale. Der ausgeleuchtete Bereich der ersten Schale ist mit A6.1 bezeichnet, der ausgeleuchtete Bereich der zweiten Schale mit A6.2, der ausgeleuchtete Bereich der dritten Spiegelschale mit A6.3. Zwischen dem ausgeleuchteten Bereich der ersten Spiegelschale A6.1 und dem ausgeleuchteten Bereich der zweiten Spiegelschale A6.2 besteht ein Abstand AB1 und zwischen dem ausgeleuchteten Bereich der zweiten Spiegelschale A6.2 und dem ausgeleuchteten Bereich der dritten Spiegeischale ein nicht ausgeleuchteter Bereich AB2. Die Abstände AB1 und AB2 sind so bemessen, dass bei Deformation der Spiegelschalen, beispielsweise durch eine thermische Verformung, die ausgeleuchteten Bereiche der Ebene 1103, in der das erste facettierte optische Element mit Feldfacetten angeordnet ist, nicht überlappen. Die Ausleuchtung weist eine Symmetrieachse SMA auf. Vorliegend handelt es sich bei der Symmetrieachse SMA der Ausleuchtung um eine vierzählige Symmetrieachse.

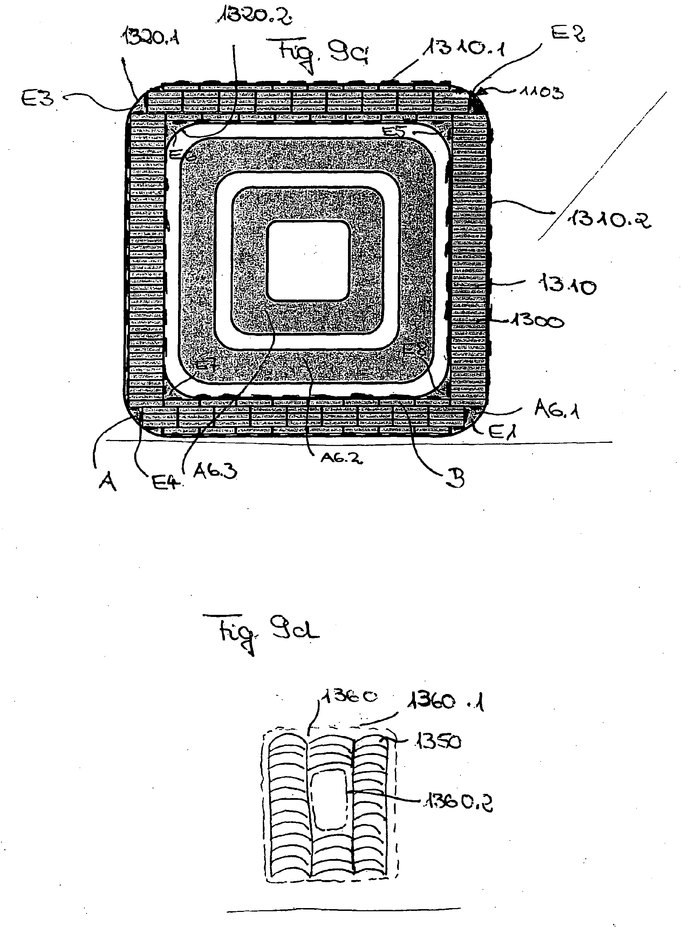

In Figur 9c ist die Anordnung der Feldfacetten in der Ausleuchtung A6.1 der ersten Spiegelschale in der Ebene 1103 gezeigt. Die einzelnen Feldfacetten sind mit Bezugsziffern 1300 bezeichnet. Sämtliche Feldwaben 1300 liegen innerhalb der AusleuchtungA6.1, der von den durchgezogenene Linien 1320.1, 1320.2 umschlossen wird. Die in der Ausleuchtung A6.1 liegenden Feldwaben bzw. Feldfacetten 1300 sind vollständig ausgeleuchtet. In vorliegendem Fall ist die Ausleuchtung weitgehend rechteckig und die Form der Feldfacetten rechteckig. Die Feldfacetten liegen in einem Bereich 1310, der durch die strichpunktierten Linien 1310.1, 1310.2 umschlossen wird. Dieser Bereich umschließt eine Fläche B. Die Ausleuchtung, d.h. der durch die erste Spiegelschale ausgeleuchtete Bereich A6.1 besitzt eine Fläche A. Wie aus Fig. 9c für die Ausleuchtung durch die erste Spiegelschale hervorgeht, wird der geometrische Lichtverlust minimiert, wenn sich der Bereich 1310, in dem die Feldfacetten zu liegen kommen, weitgehend mit dem beispielsweise durch die erste Kollektorschale ausgeleuchteten Bereich A6.1 überdeckt. Wie aus Figur 9c hervorgeht, sind einzig die Eckbereiche E1, E2, E3, E4, E5, E6, E7, E8 der Ausleuchtung A6.1 Bereiche in dienen keine Rasterelemente angeordnet sind. Bevorzugt ist es wenn der Bereich 1310 vollständig ausgeleuchtet wird, aber die Ausleuchtung nicht mehr als die 1,2 -fache Fläche B des Bereiches 1310 beträgt, also für die Fläche B des Bereiches 1310 und die Fläche A der Ausleuchtung A6.1 beispielsweise durch die erste Spiegelschale gilt:

$$A \leq B \leq 1{,}2 \bullet A,$$

bevorzugt

$$1{,}05 \bullet A \leq B \leq 1{,}1$$

Das oben dargestellte Beispiel wurde für die Ausleuchtung eines Bereiches durch eine erste Spiegelschale eines genesteten Kollektors detailliert beschrieben. Selbstverständlich kann der Fachmann ohne erfinderisches Zutun dies auch auf die anderen Spiegelschalen übertragen, bzw. auf die gesamte durch alle Spiegelschalen in der Ebene ausgeleuchteten Bereiche. Für den Gesamtbereich ergibt sich beispielsweise die oben angegebene Relation durch Summierung der Anteile der einzelnen Spiegelschalen. Die durch die zweite und dritte Spiegelschale hervorgerufene Ausleuchtung ist mit den Bezugsziffern A6.2 für die zweite Spiegelschale und A6.3 für die dritte Spiegelschale bezeichnet.

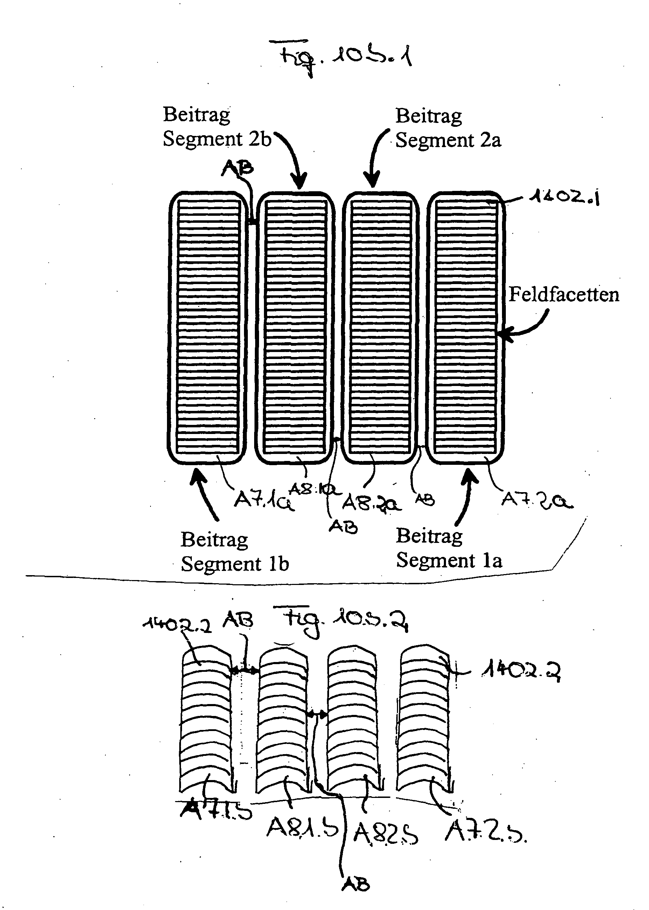

In Figur 9d ist ein erstes optisches Element mit Feldrasterelementen, die in der Form an das ausgeleuchtete Feld angepasst sind, und die Ausleuchtung eines derartigen Feldrasterelementes angegeben. Wie zuvor beschrieben sind Feldrasterelemente bzw. Feldfacetten, welche die Form des auszuleuchtenden Feldes in der Objektebene aufweisen, beispielsweise aus der US 6,195,201 bekannt geworden. In der US 6,195,201 ist die Form des Feldes in der Objektebene kreisbogenförmig, so dass die einzelnen Feldfacetten ebenfalls bogenförmig ausgebildet sind. Die einzelnen bogenförmigen Feldfacetten sind mit der Bezugsziffer 1350 gekennzeichnet. Die bogenförmigen Feldfacetten sind in einem Bereich 1360 angeordnet, der durch die strichpunktierten Linien 1360.1, 1360.2 umschlossen wird. Da die bogenförmigen Feldfacetten. 1350 in diesem Ausführungsbeispiel in einem weitgehend rechteckigen Bereich angeordnet sind, ist die durch den Kollektor hervorgerufene Ausleuchtung A6a.1 in der Ebene, in der die Feldfacettenelemente angeordnet sind, ebenfalls weitgehend rechteckförmig. In Fig. 9d ist die Ausleuchtung durch einen Kollektor mit geschlossener Fläche gezeigt, der nur eine einzige Spiegelschale umfasst ohne hierauf beschränkt zu sein. Selbstverständlich können auch mehrschalige Kollektoren eingesetzt werden, wie im Fall von rechteckigen Feldfacetten zuvor beschrieben wurde. Des Weiteren sind selbstverständlich auch andere Anordnungen der bogenförmigen Elemente, beispielsweise in Blöcken wie für rechteckige Feldwaben bzw. Feldfacetten in Figur 10b2 gezeigt, möglich.

Die Feldfacetten sind für Beleuchtungssysteme bzw. Projektionsbelichtungsanlagen, die wie in Figur 1 dargestellt reflektiv für die Mikrolithographie mit Wellenlängen ≤ 193 nm, insbesondere ≤ 100 nm, insbesondere im EUV-Wellenlängenbereich von ≤ 15 nm ausgeführt sind, ebenfalls reflektiv, bspw. als einzelne Facettenspiegel ausgeführt. Die in Figur 1 gezeigte Projektionsbelichtungsanlage für die Lithographie im EUV-Wellenlängenbereich ist aber nur beispielhaft und keineswegs einschränkend für die Erfindung.

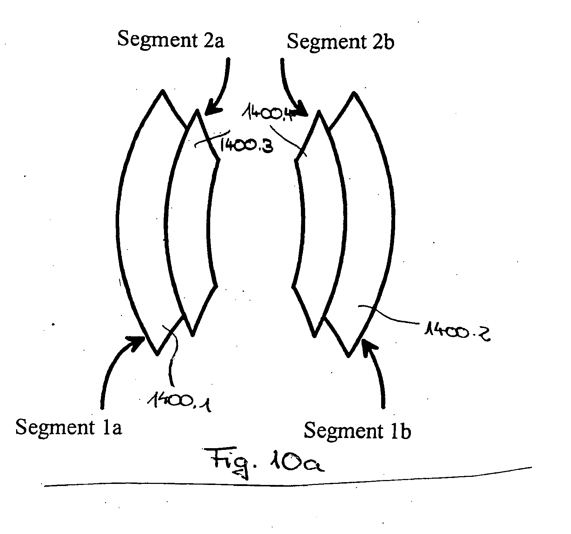

Alternativ zu einer Ausführungsform der Erfindung mit geschlossenen Spiegelschalen ist es auch möglich alleine mit Schalensegmenten einen Kollektor aufzubauen. Dies ist in Figur 10a und die mit Hilfe der Schalensegmente erreichte Ausleuchtung in der Ebene, in der das erste facettierte optische Element mit Feldfacetten bzw. Feldrasterelemente angeordnet ist, ist in Figur 10b gezeigt.

Das erste Schalen- oder Spiegelsegment ist mit den Bezugsziffern 1400.1, 1400.2, das zweite Schalen- oder Spiegelsegment mit den Bezugsziffern 1400.3 und 1400.4 bezeichnet. In Figur 10b1-10b2 sind die vier ausgeleuchteten Bereiche in der Ebene gezeigt, in der das erste facettierte Element mit Feldrasterelementen angeordnet ist. Figur 10b1 zeigt eine Ausführungsform mit rechteckigen Feldfacetten. Hierbei bezeichnet A7.1a und A7.2a die Ausleuchtung in der Ebene 103, die von dem Spiegelsegment 1400.1 und 1400.2 herrührt. Die Ausleuchtungen A8.1a und A8.2a bezeichnen die Ausleuchtungen, die mit Hilfe der Spiegelsegmente 1400.3 und 1400.4 vorgenommen wurden. Wie hier deutlich zu erkennen ist, weisen die vier auszuleuchtenden Bereiche A7.1a, A7.2a, A8.1a, A8.2a, zueinander einen Abstand AB auf. In Figur 10b.1 sind die rechteckigen Feldfacetten 1402.1 alle innerhalb der ausgeleuchteten Bereiche A7.1a, A7.2a, A8.1a, A8.2a angeordnet. In Figur 10b.2 ist eine Ausgestaltung der Erfindung gezeigt, bei der die Feldfacetten 1402.2 bogenförmig ausgebildet ist. Die von den Spiegelsegmenten 1400.1 und 1400.2 ausgeleuchteten Bereiche sind mit A7.1b, A 7.2b, A8.1 b und A8.2b bezeichnet Die Abstände zwischen den Ausleuchtungen sind wieder mit AB angegeben.

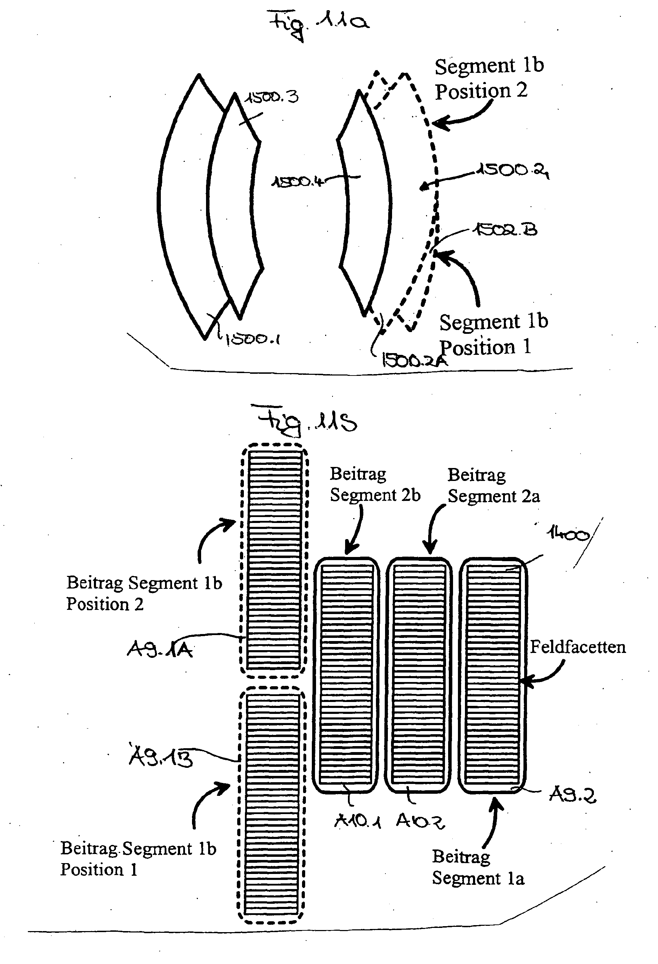

Bei einer Ausführungsform mit Schalensegmenten ist es in einer weitergebildeten, in Figur 11a und Figur 11b gezeigten Ausführungsform möglich, beispielsweise eine Schale drehbar zu lagern, so dass der Kollektor in zwei Zuständen betrieben werden kann, nämlich in einer ersten und in einer zweiten Position. Abhängig von der Stellung des drehbaren Segmentes wird dann in der Ebene 103 in Figur 1, in der das erste facettierte optische Element mit Feldfacetten angeordnet ist, jeweils ein unterschiedlicher Bereich von Feldfacetten ausgeleuchtet. In Figur 11a ist wiederum ein Kollektor aufgebaut aus zwei Schalensegmenten 1500.1, 1500.2, 1500.3 und 1500.4 dargestellt. Das Segment 1500.2 ist in zwei Positionen 1500.2A und 1500.2B verbringbar. In Figur 11b ist die zugeordnete Ausleuchtung in der Ebene 103 gemäß Figur 1, in der das erste facettierte optische Element mit Feldrasterelementen angeordnet ist, dargestellt. Die Beiträge der Schalensegmente 1500.1, 1500.3, 1500.4 entsprechen den Ausleuchtungen in Figur 10b und sind mit A10.1, A10.2, und A9.2 bezeichnet. Das drehbare Segment 1500.2 weist in der Position 1500.2A die Ausleuchtung A9.1A und in der Position 1500.2B die Ausleuchtung A9.1B auf. Wie man deutlich aus Figur 11b erkennt, kann durch ein Verdrehen des Segmentes 1500.2 in die beiden angegebenen Positionen eine unterschiedliche Ausleuchtung eingestellt werden.

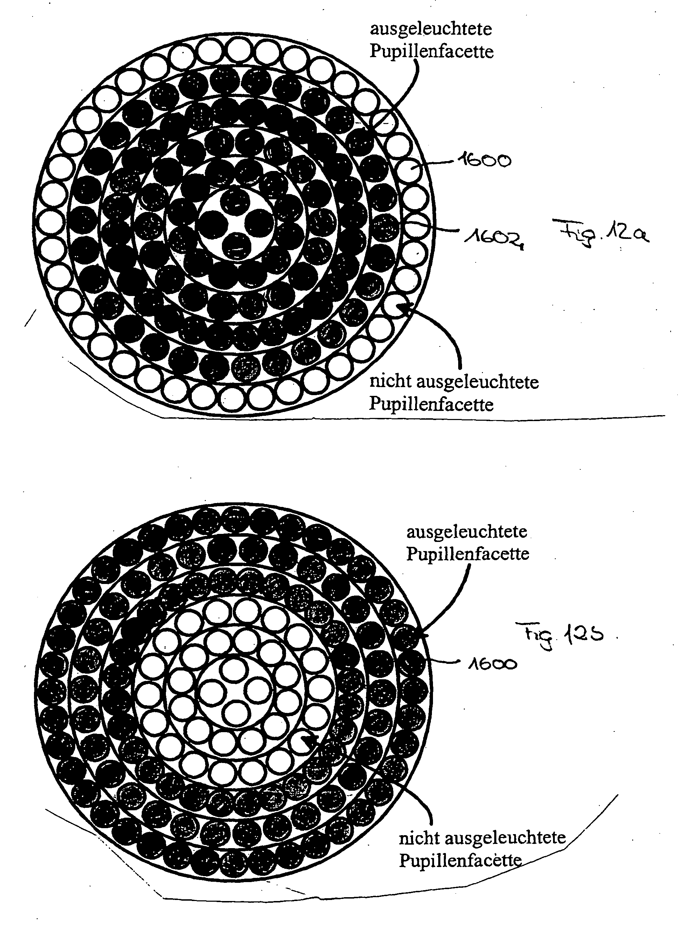

Sind, wie in der US 6,658,084 offenbart, unterschiedlichen Feldfacetten unterschiedliche Pupillenfacetten des zweiten Rasterelementes 104 in Figur 1 zugeordnet, so können durch ein Verdrehen der Spiegelschale 1500.2 unterschiedliche Pupillenfacetten ausgeleuchtet und damit unterschiedliche Settings in der Austrittspupille des in Figur 1 dargestellten Beleuchtungssystems eingestellt werden. Dies ist in Figur 12a und 12b dargestellt.

In Figur 12a und 12b ist die Ausleuchtung auf dem zweiten facettierten optischen Element 104 mit Pupillenfacetten dargestellt.

Befindet sich das Schalensegment 1500.2, wie in Figur 11a dargestellt, in der ersten Position, d.h. in der Position 1500.2A, so wird die Ausleuchtung gemäß Figur 12a erreicht, d.h. die äußersten Pupillenfacetten 1600 sind nicht ausgeleuchtet, die inneren Pupillenfacetten 1602 sind ausgeleuchtet, so dass sich ein konventionelles kreisförmiges Setting in der Austrittspupille ergibt. Wird das Segment 1502 in die zweite Position 1502B verbracht, so ergibt sich die Ausleuchtung gemäß Figur 12b. Die ausgeleuchteten Pupillenfacetten 1600 befinden sich im äußeren Bereich, die nicht ausgeleuchteten Pupillenfacetten im inneren Bereich. Es ergibt sich dann in der Austrittspupille ein ringförmiges Setting.

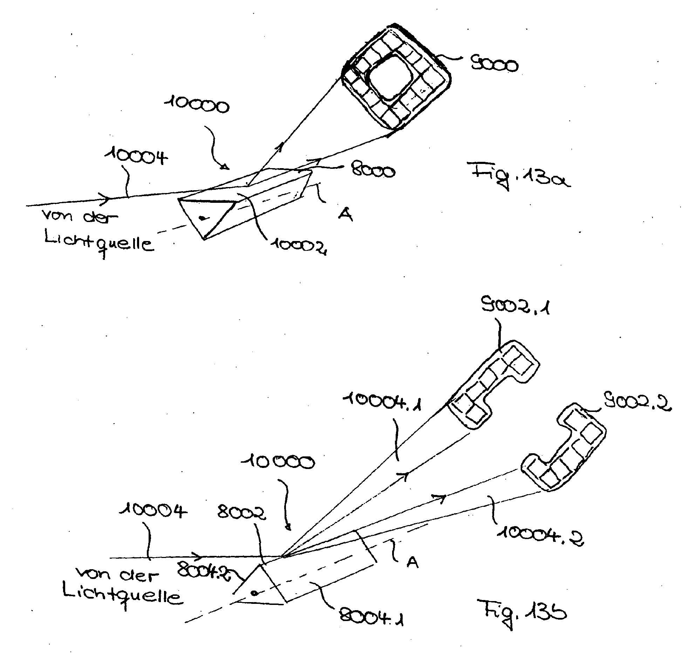

Anstelle die Schalensegmente wie in den Figuren 11a und 11b gezeigt in unterschiedliche Positionen zu verbringen, um wie in den Figuren 12a und 12b gezeigt, unterschiedliche Ausleuchtungen auf dem zweiten facettieren optischen Element mit Pupillenfacetten und damit Setting Einstellungen zu erzeugen, ist es auch möglich ein optisches Einstellelement im Lichtweg nach dem Kollektor und vor dem facettierten optischen Element mit Rasterelemente wie in den Figuren 13a und 13b gezeigt einzubringen. Dieses optische Einstellelement kann beispielsweise anstelle oder zusätzlich zum Planspiegels 300 in dem Beleuchtungssystem gemäß Figur 1 vorgesehen sein. Wird das Einstellelement nunmehr in unterschiedliche Positionen verfahren, so werden hierdurch unterschiedliche Bereiche des ersten facettierten optischen Elementes wie in den Figuren 13c bis 13c gezeigt ausgeleuchtet und damit unterschiedlich Pupillenfacetten auf dem Pupillenfacettenspiegel.

Als optisches Einstellelement ist in den Figuren 13a und 13b ein sogenannter Dachkantenspiegel 10000 gezeigt, der um eine Achse A drehbar ist und in zwei unterschiedliche Positionen verbracht werden kann. In einer ersten Position, wie in Figur 13a gezeigt, wirkt der Dachkantenspiegel als erster Spiegel 8000 im Lichtweg wie ein Planspiegel, beispielsweise wie der in Figur 1 gezeigte Planspiegel 300.

Die Ausleuchtung auf dem optischen Element , das in Figur 1 mit 102 bezeichnet wird, und damit den ersten Rasterelementen, wird beispielsweise durch die Form der Spiegelschalen des Kollektors 3 bestimmt. Sind diese Spiegelschalen im Wesentlichen deformiert wie in Figur 4b und Figur 4d beschrieben, so wird eine im Wesentlichen rechteckige Ausleuchtung 9000, wie in Figur 13a dargestellt, mit einer Mittenobskuration ausgebildet. Das Lichtbündel, das von einer nicht dargestellten Lichtquelle auf den planen Teil 10002 des Dachkantenspiegels auftrifft, wird unaufgeteilt auf das optische Element mit ersten Rasterelementen reflektiert.

Wird nunmehr der Dachkantenspiegel 10000 um die optische Achse A in die in Figur 13b gezeigte Stellung verdreht, so wird ein Lichtbündel 10004, das von einer nicht dargestellten Lichtquelle auf den Dachkantenspiegel auftrifft in zwei Lichtbündel 10004.1 und 10004.2 aufgeteilt, und zwei Bereiche 9002.1, 9002.2 des Feldfacettenspiegels ausgeleuchtet. Da in Figur 13b andere erste Rasterelemente d.h. Feldrasterelemente wie in Figur 13a ausgeleuchtet werden, kann durch die Zuordnung von Feldfacetten zu Pupillenfacetten, wie in den Figuren 13b bis 13c gezeigt, jeweils ein unterschiedliches Setting in der Austrittspupille eingestellt werden. In der zweiten Stellung stellt der Dachkantspiegel eine zweite und dritte reflektierende Fläche in Form eines zweiten Spiegels 8002 mit zwei reflektierenden Flächen 8004.1, 8004.2 zur Verfügung.

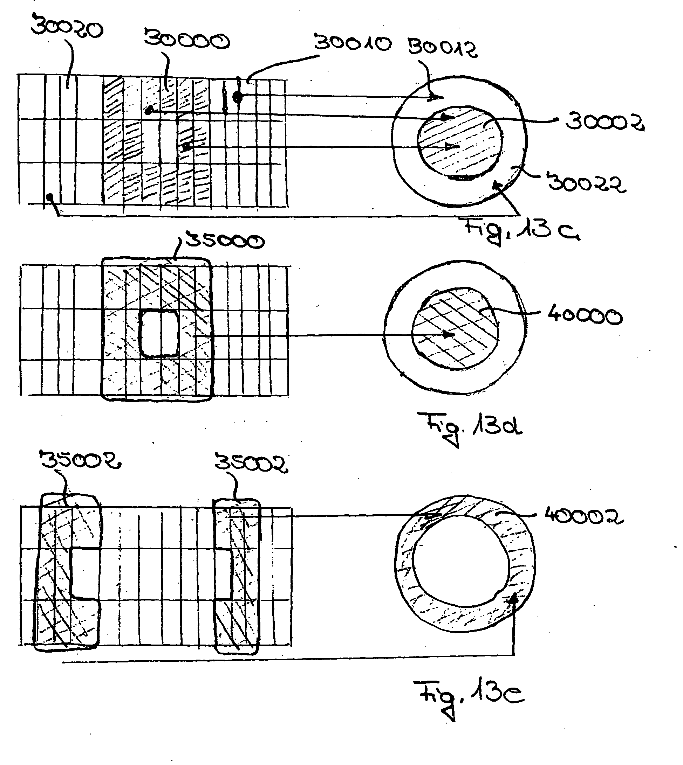

In Figur 13c ist zunächst allgemein die Zuordnung von Feldrasterelementen zu unterschiedlichen Pupillenrasterelementen gezeigt. Dabei sind die Feldrasterelemente im Bereich 30000 den Pupillenrasterelementen im Bereich 30002 zugeordnet, die Feldrasterelemente im Bereich 30010 den Pupillenrasterelementen im Bereich 30012 und die Feldrasterelemente 30020 den Pupillenrasterelementen 30022.

Wird nunmehr, wie in Figur 13d gezeigt, ein Bereich 35000 wie in Figur 13a gezeigt auf dem optischen Element mit Feldrasterelementen ausgeleuchtet, so wird im Wesentlichen eine konventionell gefüllte Pupille 40000 ausgeleuchtet.

Wird der Dachkantenspiegel in die in Figur 13b gezeigte Stellung verbracht, so wird eine Ausleuchtung 35002 gemäß Figur 13e auf dem optischen Element mit Feldrasterelementen eingestellt. In der Pupille wird eine kreisförmige Ausleuchtung 40002 realisiert, da durch die Ausleuchtung von anderen Feldrasterelementen als in Figur 13c andere Pupillenrasterelemente ausgeleuchtet werden, die wiederum zu einer anderen Ausleuchtung in der Austrittspupille des Beleuchtungssystems führen. Anstelle die Ausleuchtung des ersten optischen Elementes mit Feldrasterelementen über einen verdrehbaren Dachkantenspiegel zu ändern, ist es auch möglich Spiegelelement zu wechseln und so unterschiedliche Ausleuchtungen auf dem ersten Rasterelement zu erreichen, beispielsweise mit Hilfe eines Spiegelwechslers beispielsweise eines Spiegelrades auf dem unterschiedliche Spiegel angeordnet sind. Beispielsweise können auf einem dem Spiegelrad ein Planspiegel oder aber auch gekippte Spiegel mit zwei Spiegelflächen oder mit asphärischen Oberflächen angeordnet sein.

In der Erfindung wird erstmals ein Kollektor für ein EUV-Projektionsobjektiv angegeben, der gegenüber den aus der US 2003-0043455A1 bekannten Kollektoren eine Ausleuchtung mit einem niedrigeren geometrischen Lichtverlust aufweist. In einer weiteren Ausführungsform werden Schwankungen in der scanintegrierten Energie in der Feldebene, beispielsweise aufgrund von Deformationen der einzelnen Spiegelschalen, verringert.

Es versteht sich für den Fachmann, dass von der vorliegenden Erfindung auch Ausführungsbeispiele umfasst sind, die sich durch Kombination von Merkmalen der oben dargestellten Ausführungsbeispiel oder durch Austausch von Merkmalen der oben dargestellten Ausführungsbeispiele ergeben.

Die vorliegende Erfindung umfasst die Aspekte, die in den nachfolgenden Sätzen niedergelegt sind, die einen Teil der Beschreibung darstellen, aber keine Ansprüche in Übereinstimmung mit der Entscheidung J15/88 der Beschwerdekammer sind:

Sätze:

1. Kollektor für Beleuchtungssysteme für eine Wellenlänge $\leq$ 193 nm, bevorzugt $\leq$ 126 nm, besonders bevorzugt EUV-Strahlung umfassend: eine erste Spiegeischale (1212.1) und eine zweite Spiegelschale (1212.2), wobei die erste Splegelschale (1212.1) innerhalb der zweiten Spiegelschale (1212.2) angeordnet ist, und die erste Spiegelschale (1212.1) und/oder die zweite Spiegelschale (1212.2) eine geschlossene Spiegelfläche ist, die einen rotationssymmetrischen Anteil und einen nicht rotationssymmetrischen Anteil umfasst.

2. Kollektor gemäß Satz 1, wobei die erste (1212.1) und/oder die zweite Spiegelschale (1212.2) ein erstes Segment mit einer ersten optischen Fläche und ein zweltes Segment mit einer zweiten optischen Fläche umfasst.

3. Kollektor gemäß Satz 2, wobei das erste Segment ein Rotationshyperboloid (800) ist und das zweite Segment ein Rotationsellipsoid (802) ist, wobei der nicht rotationssymmetrischer Anteil zu dem Rotationshyperboloiden und/oder Rotationsellipsoiden hinzuaddiert oder abgezogen wird.

4. Kollektor gemäß einem der Sätze 1 bis 3,
wobei wenigstens die erste Spiegelschale (1212.1) und/oder die zweite Spiegelschale (1212.2) eine Symmetrieachse aufweisen.

5. Kollektor gemäß Satz 4,
wobei die Symmetrieachse eine gemeinsame Symmetrieachse für die erste Spiegelschale (1212.1) und die zweite Spiegelschale (1212.2) sind.

6. Kollektor gemäß Satz 4 oder 5,
wobei die erste und/oder die zweiten Spiegelschale eine n-zählige Symmetrie um die Symmetrieachse aufweisen,
wobei n eine natürliche ganze Zahl ist.

7. Kollektor gemäß Satz 6,
wobei die Symmetrie um die Symmetrieachse eine der nachfolgenden Symmetrien ist:

- eine zweizählige Symmetrie,
- eine dreizählige Symmetrie,
- eine vierzählige Symmetrie,
- eine fünfzählige Symmetrie
- eine sechszählige Symmetrie
- eine siebenzählige Symmetrie
- eine achtzählige Symmetrie

8. Kollektor gemäß einem der Sätze 1 bis 7, wobei der Kollektor Licht einer Lichtquelle aufnimmt und in eine Ebene, die im Lichtweg hinter dem Kollektor liegt, leitet, wobei der nicht rotationssymmetrische Anteil der geschlossenen Spiegelschale derart gewählt ist, dass in der Ebene eine Ausleuchtung Im Wesentlichen in rechteckiger Form vorliegt,

9. Kollektor gemäß einem der Sätze 1 bis 8, wobei der Kollektor im Inneren der Spiegelschale die am nächsten zur Achse angeordnet ist, eine Blende aufweist.

10. Kollektor gemäß einem der Sätze 1 bis 9, wobei
wenigstens die erste Spiegelschale (1212.1) und
eine zweite Spiegelschale (1212.2) Licht in eine Ebene leiten, die in einem Lichtweg hinter dem Kollektor zum Liegen kommt,
so dass in dieser Ebene eine erste Ausleuchtung (A6.1) und eine zweite Ausleuchtung (A6.2) ausgebildet wird, und erste und zweite Ausleuchtung (A6.1, A6.2) einen Abstand zueinander aufweisen.

11. Kollektor nach Satz 10, dadurch gekennzeichnet,
dass der Abstand der ersten und der zweiten Ausleuchtung (A6.1, A6.2) derart gewählt ist, dass bei einer thermalen Deformation der ersten oder der zweiten Spiegelschale oder bei einer Veränderung der Lichtquelle in Form oder Abstrahlcharakteristik die erste und die zweite Ausleuchtung (A6.1, A6.2) in der Ebene nicht überlappen.

12. Kollektor nach Satz 11, dadurch gekennzelchnet,
dass der Abstand größer ist als 1 mm, bevorzugt größer ist als 5 mm.

13. Kollektor nach einem der Sätze 10 bis 12, wobei in der Ebene eine Vielzahl von Rasterelementen in einer Anordnung mit einer Form zur Verfügung gestellt wird und die erste und/oder zweite Ausleuchtung (A6.1, A6.2) eine geometrische Form aufweist, die im Wesentlichen der Form der Anordnung der Vielzahl von Rasterelementen entspricht.

14. Kollektor nach einem der Sätze 10 bis 13, wobei die Ausleuchtung im Wesentlichen eine rechteckige Form, insbesondere eine quadratische Form aufweist.

15. Kollektor für Beleuchtungssysteme für eine Wellenlänge ≤ 193 nm, bevorzugt ≤ 126 nm, besonders bevorzugt EUV-Wellenlängen umfassend:

wenigstens eine erste Spiegelschale (1212.1) oder ein erstes Schalensegment und
eine zweite Spiegelschale (1212.2) oder ein zweltes Schalensegment zur Aufnahme von Licht einer Lichtquelle, wobei die erste Splegeischale oder das erste Schalensegment und die zweite Schale oder das zweite Schalensegment das Licht aufnimmt und in eine Ebene, die in einem Lichtweg hinter dem Kollektor zum Liegen kommt, leitet,
so dass in der Ebene eine erste Ausleuchtung (A6.1) und eine zweite Ausleuchtung (A6.2) ausgebildet wird, und erste und zweite Ausleuchtung (A6.1, A6.2) einen Abstand zueinander aufweisen.

16. Kollektor nach Satz 15, dadurch gekennzeichnet,
dass der Abstand der ersten und der zweiten Ausleuchtung (A6.1, A6.2) derart gewählt ist, dass bei einer thermalen Deformation der ersten oder der zweiten Spiegelschale oder des ersten oder des zweiten Schatensegments oder bei einer Veränderung der Lichtquelle in Form oder Abstrahlcharakteristik die erste und die zweite Ausleuchtung (A6.1, A6.2) in der Ebene nicht überlappen.

17. Kollektor nach Satz 15 oder 16, dadurch gekennzeichnet,
dass der Abstand größer ist als 1 mm, bevorzugt größer ist als 5 mm.

18. Kollektor nach einem der Sätze 15 bis 17, wobei in der Ebene eine Vielzahl von Rasterelement in einer Form angeordnet sind und die erste und/oder zweite Ausleuchtung (A6.1, A6.2) eine geometrische Form aufweist, die im Wesentlichen der Form der Anordnung der Vielzahl von Rasterelementen in der Ebene entspricht.

19. Kollektor nach einem der Sätze 15 bis 18, wobei die erste und die zweite Ausleuchtung im Wesentlichen eine rechteckige Form, insbesondere eine quadratische Form aufweist.

20. Kollektor nach einem der Sätze 15 bis 19, wobei die erste Schale und die zweite Schale geschlossene Flächen sind, die rotationssymmetrisch um eine Rotationsachse sind.

21. Beleuchtungssystem für eine Wellenlänge ≤ 193 nm, bevorzugt ≤ 126 nm, insbesondere im EUV-Wellenlängenbereich umfassend einen Kollektor (3), gemäß einem der Sätze 1 bis 20, wobei der Kollektor (3) im Lichtweg von einer Lichtquelle (1) zu einer Ebene (103,1103), in der eine Ausleuchtung vorliegt, zwischen der Lichtquelle (1) und der Ebene (103, 1103) angeordnet ist und in oder nahe der Ebene (103) ein facettiertes optisches Element (102) zur Verfügung gestellt wird.

22. Beleuchtungssystem nach Satz 21, wobei das facettierte optische Element (102) eine Vielzahl von Feldrasterelementen (402, 502, 1300) umfasst.

23. Beleuchtungssystem nach Satz 22, wobei die Feldrasterelemente (1300) des facettierten optischen Elementes derart angeordnet sind, dass sie in der Ebene (1103) im Wesentlichen im Bereich der Ausleuchtung (A6.1, A6.2, A6.3) angeordnet sind.

24. Beleuchtungssystem nach einem der Sätze 20 bis 23, wobei das Beleuchtungssystem eine Austrittspupillenebene (140) und/oder eine Pupillenabene aufweist und das facettierte optische Element derart ausgebildet ist, dass unabhängig von einer Form Ausleuchtung in der Ebene (103) Lichtquellenbilder in eine Austrittspupillenebene (140) und/oder eine Pupillenebene (105) weitgehend objekttreu abgebildet werden.

25. Beleuchtungssystem gemäß Satz 24, wobei das facettierte optische Element Feldrasterelemente aufweist und die Feldrasterelemente eine optische Wirkung und eine Aspharizltät aufweisen.

26. Beleuchtungssystem gemäß Satz 25, wobei die Asphärizltät Unterschiedlicher Feldrasterelemente verschieden ist.

27. Beleuchtungssystem nach einem der Sätze 21 bis 26, wobei das Beleuchtungssystem eine Pupillenebene (105) und ein weiteres facettiertes optisches Element (104) aufweist, wobei das weitere facettierte optische Element (104) in oder nahe der Pupillenebene (105) angeordnet ist.

28. Beleuchtungssystem nach Satz 27, wobei das weitere optische Element eine Vielzahl von Puptlienrasterelementen umfasst,

29. Beleuchtungssystem nach Satz 28, wobei je einem einer Vielzahl von Feldrasterelementen ein Pupillenrasterelement gemäß einer ersten Zuordnung zugeordnet ist und je einem einer zweiten Vielzahl von Feldrasterelementen ein Pupillenrasterelement gemäß einer zweiten Zuordnung zugeordnet ist.

30. Beleuchtungssystem nach Satz 29, wobei wenigstens das erste Schalensegment (1500.1, 1500.2, 1500.3, 1500.4) und/oder das zweite Schalensegement in eine erste Position und in eine zweite Position (1500.2B) verbracht werden kann und in der ersten Position (1500.2A) die erste Vielzahl von Feldrasterelementen und in der zweiten Position die zweite Vielzahl von Feldrasterelementen ausgeleuchtet wird.

31. Beleuchtungssystem nach Satz 29, wobei im Lichtweg nach dem Kollektor und vor dem facettierten optischen Element (102) ein optisches Einstellelement (10000) angeordnet ist, wobei das optische Einstellelement (10000) in einer ersten Position eine erste Vielzahl von Feldrasterelementen und in einer zweiten Position eine zweite Vielzahl von Feldrasterelementen ausleuchtet.

32. "Beleuchtungssystem nach Satz 31, wobei in der ersten Position des optischen Einstellelementes (10000) ein erster Spiegel (8000) in den Lichtweg von der Lichtquelle zum facettierten optischen Element verbracht wird und in einer zweiten Position ein zweiter Spiegel (8002) in den Lichtweg von der Lichtquelle zum facettierten optischen Element verbracht wird.

33. Beleuchtungssystem nach Satz 29, wobei in den Lichtweg nach dem Kollektor und vor dem facettierten optischen Element unterschiedliche optische Elemente zur Ausleuchtung einer unterschiedilchen Vielzahl von Feldrasterelementen eingebracht werden.

34. Beleuchtungssystem nach Satz 33, wobei die unterschiedlichen optischen Elemente unterschiedliche Spiegel sind.

35. Beleuchtungssystem nach Satz 34, wobei die unterschiedlichen Spiegel auf einem um eine Achse drehbaren Spiegelträger angeordnet sind.

36. Beleuchtungssystem nach einem der Sätze 21 bis 35, wobei die Pupillenebene (105) eine konjugierte Ebene zu einer Austrittspupillenebene (140) des Beleuchtungssystems ist.

37. Beleuchtungssystem nach einem der Sätze 29 bis 37, wobei die erste Zuordnung einer erste Ausleuchtung in einer Austrittspupillenebene (140) und die zweite Zuordnung einer zweite Ausleuchtung in der Austrittspupillenebene (140) entspricht, wobei die erste Ausleuchtung verschieden von der zweiten Ausleuchtung ist.

38. Projektionsbelichtungsanlage für die Mikrolithographie mit Wellenlängen ≤ 193 nm, umfassend
eine Lichtquelle (1);
ein Beleuchtungssystem gemäß einem der Sätze 21 bis 37 zur Ausleuchtung eines Feldes In einer Feldebene(114) und
einem Projektionsobjektiv (128) um ein Objekt in der Feldebene (114) in ein Bild in einer Bildebene (124) des Projektionsobjektives (128) abzubilden.

39. Verfahren zur Herstellung mikroelektronischer Bauteile, umfassend die nachfolgenden Schritte:

es wird mit Hilfe einer Projektionsbelichtungsanlage gemäß Satz 38 eine strukturierte Maske auf eine lichtempfindliche Schicht, die sich in der Bildebene (124) des Projektionsobjektives befindet, abgebildet;
die strukturierte Maske wird entwickelt, ergebend einen Teil des mikroelektronlsche Bauteils oder das mikroelektronische Bauteil selbst.

40. Beleuchtungssystem für Wellenlängen ≤ 193 nm, bevorzugt ≤ 126 nm, besonders bevorzugt EUV-Wellenlängen, umfassend eine Lichtquelle (1000), eine erste Ebene(1003) sowie eine im Lichtweg von der Lichtquelle (1000) zur ersten Ebene nach der ersten Ebene (1005) angeordnete zweite Ebene (1103), wobei in der ersten Ebene im Wesentlichen eine ring- oder kreisförmige Ausleuchtung zur Verfügung gestellt wird und wobei das Beleuchtungssystem wenigstens ein optisches Element (1105, 1302, 103) aufweist, das im Lichtweg nach der ersten Ebene angeordnet und derart ausgestattet ist, dass die im Wesentlichen ring- oder kreisförmige Ausleuchtung in der ersten Ebene (1005) in eine im Wesentlichen nicht ring- oder kreisförmige Ausleuchtung, insbesondere eine im Wesentlichen rechteckige, insbesondere im Wesentlichen quadratische Ausleuchtung in der zweiten Ebene (1103) transformiert wird.

41. Beleuchtungssystem nach Satz 40, wobei in oder nahe der zweiten Ebene ein facettiertes optisches Element (102) angeordnet ist.

42. Beleuchtungssystem nach Satz 41, wobei das facettierte optische Element (102) wenigstens ein Rasterelement aufweist.

43. Beleuchtungssystem nach Satz 42, wobei das Rasterelement im Wesentlichen eine rechteckige Gestalt aufweist.

44. Beleuchtungssystem nach Satz 42, wobei das Rasterelement im Wesentlichen eine bogenförmige Gestalt aufweist.

45. Beleuchtungssystem nach einem der Sätze 41 bis 44, wobei das Beleuchtungssystem eine Austrittspupillenebene (140) und/oder eine Pupillenebene (105) aufweist und das facattierte optische Element derart ausgebildet ist, dass unabhängig von der im wesentlichen quadratischen Ausleuchtung in der zweiten Ebene (1103) Lichtquellenbilder in die Austrittspupillenebene (140) und/oder Pupillenebene (105) weitgehend objekttreu abgebildet werden.

46. Beleuchtungssystem gemäß Satz 45, wobei das facettierte optische Element Feldrasterelement aufweist und die Feldrasterelemente eine optische Wirkung und eine Asphärizität aufweisen.

47. Beleuchtungssystem gemäß Satz 46, wobei die Asphärizität unterschiedlicher Feldrasterelemente verschieden ist,

48. Beleuchtungssystem gemäß einem der Sätze 40 bis 47, wobei im Lichtweg nach der Lichtquelle und vor dem optische Element (103) ein Kollektor angeordnet ist, der das Licht der Lichtquelle aufnimmt und in der ersten Ebene eine im wesentlichen ring- oder kreisförmige Ausleuchtung zur Verfügung stellt.

49. Beleuchtungssystem gemäß Satz 48, wobei der Kollektor wenigstens eine geschlossene Spiegelfläche umfasst.

50. Beleuchtungssystem nach Satz 49, wobei die geschlossene Spiegelfläche eine Spiegelschale ist, wobei die Spiegelschale um eine Achse (HA) rotationssymmetrisch angeordnet ist.

51. Beleuchtungssystem nach einem der Sätze 40 bis 50, wobei das optische Element ein Spiegel mit einer asphärischen Spiegelfläche (1105) ist.

52. Beleuchtungssystem bei einem der Sätze 40 bis 50, wobei das optische Element ein Gitterelement (1302) ist, wobei das Gitterelement (1302) eine optische Wirkung aufweist.

53. Projektionsbelichtungsanlage für die Mikrolithographie mit Wellenlängen ≤ 193 nm, umfassend
eine Lichtquelle:

ein Beleuchtungssystem gemäß einem der Sätze 40 bis 52, die ein Feld in einer Feldebene (114) ausleuchtet und ein Projektionsobjektiv (128), das ein Objekt in der Feldebene in ein Bild in einer Bildebene des Projektionsobjektives abbildet.

54. Verfahren zur Herstellung mikroelektronischer Bauteile, umfassend die nachfolgenden Schritte:

es wird mit Hilfe einer Projektionsbelichtungsanlage gemäß Satz 53, eine strukturierte Maske auf eine lichtempfindliche Schicht, die sich in der Bildebene des Projektionsobjektives befindet, abgebildet;
die strukturierte Maske wird vermittelt, ergebend einen Teil des mikroelektronischen Bauteils oder des mikroelektronischen Bauteils selbst.

55. Beleuchtungssystem für Wellenlängen ≤ 193 nm umfassend eine Lichtquelle
ein erstes optisches Element sowie
ein erstes optisches Element, das eine Vielzahl von Rasterelementen (1300) umfasst, die in einer Ebene in mindestens einem ersten Bereich angeordnet sind, wobei
das erste optische Element in einem Lichtweg von der Lichtquelle zum zweiten optischen Element nach der Lichtquelle angeordnet ist und das erste optische Element derart ausgebildet ist, dass es das Licht der Lichtquelle aufnimmt und einen zweiten Bereich (A6.1) in der Ebene (1103) ausleuchtet, wobei der zweite Bereich den ersten Bereich weitgehend überdeckt.

56. Beleuchtungssystem nach Satz 55, wobei die
Rasterelemente in dem ersten Bereich (1310) in einer ersten Fläche B angeordnet sind und der ausgeleuchtete zweite Bereich (A6.1) eine zweite Fläche A aufweist und die Fläche A größer als Fläche B ist.

57. Beleuchtungssystem nach Satz 56, wobei für die
Fläche A des ausgeleuchteten Bereiches in Abhängigkeit von der Fläche B, in der die Rasterelementen angeordnet sind, gilt:

$$B \leq A \leq 1{,}2 \bullet B,$$

insbesondere

$$1{,}05 \bullet B \leq A \leq 1{,}1 \bullet B$$

58. Beleuchtungssystem nach einem der Sätze 1 bis 57, wobei die Lichtquelle eine im Wesentlichen isotrope Abstrahlcharakteristik aufweist.

59. Beleuchtungssystem für Welienlängen $\leq$ 193 nm umfassend wenigstens ein facettiertes optisches Element mit einer Vielzahl von Rasterelement, wobei die Rasterelemente des facettierten optischen Elementes in wenigstens zwei Blöcken angeordnet sind.

60. Beleuchtungssystem gemäß Satz 59, wobei die Rasterelemente Facettenspiegel sind.

61. Beleuchtungssystem gemäß Satz 60, wobei ein Feld in einer Feldebene ausgeleuchtet wird und die Rasterelemente im Wesentlichen die Form des Feldes aufweisen.

62. Beleuchtungssystem nach Satz 61, wobei die Rasterelemente bogenförmig sind.

63. Projektionsbelichtungsanlage für die Mikroüthographie mit Wellenlängen $\leq$ 193 nm, umfassend
ein Beleuchtungssystem gemäß einem der Sätze 55 bis 62, das ein Feld in einer Feldebene (114) ausleuchtet und
ein Projektionsobjektiv (128), das ein Objekt in der Feldebene in ein Bild in einer Bildebene des Projektionsobjektives abbildet,

64. Verfahren zur Herstellung mikroelektronischer Bauteile, umfassend die nachfolgenden Schritte:

es wird mit Hilfe einer Projektionsbellchtungsanlage gemäß Satz 63,
eine strukturierte Maske auf eine lichtempfindliche Schicht, die sich in der Bildebene des Projektionsobjektives befindet, abgebildet;
die strukturierte Maske wird vermittelt, ergebend einen Teil des mikroelektronischen Bauteils oder des mikroetektronischen Bauteils selbst.

65. Kollektor für Beleuchtungssysteme für eine Wellenlänge $\leq$ 193 nm, bevorzugt $\leq$ 126 nm, besonders bevorzugt EUV-Strahlung umfassend:

wenigstens eine erste Fläche (850.1) und eine zweite Fläche (850.2), wobei die erste Fläche (850.1) beabstandet zur zweiten Fläche (850.2) ist, und die erste Fläche (850.1) einer ersten Achse (854.1) zugeordnet ist und die zweite Fläche (850.2) einer zweiten Achse (854.2) zugeordnet ist und wenigstens eine Flächenfunktion K1 der ersten Fläche und/oder eine Flächenfunktion K2 der zweiten Fläche eine Flächenfunktion $K(z,\Phi)$ ist, die durch die Lage entlang der zugeordneten Achse (z) und dem zugeordneten Azimutwinkel ($\Phi$) in einer Ebene (856.1, 856.2) senkrecht auf der zugeordneten Achse (z), definiert ist, wobei wenigstens eine Flächenfunktion $K(z,\phi)$ bezüglich einer zugeordneten Achse einen rotationssymmetrischen Anteil und einen nicht rotationssymmetrischen Anteil umfasst.

66. Kollektor gemäß Satz 65,
wobei der Azimutwinkel $\Phi$ alle Werte zwischen 0 und $2\pi$ annimmt,

67. Kollektor gemäß Satz 65,
wobei der Azimutwinkel $\Phi$ Werte aus dem Bereich zwischen 0 und $2\pi$ annimmt.

68. Kollektor gemäß einem der Sätze 65 bis 67, wobei die erste Achse (856.1) und die zweite Achse (856.2) einen Winkel δ einschließen.

69. Kollektor gemäß einem der Sätze 65 bis 68, wobei die Flächenfunktion K (z,Φ stetig in z und/oder Φ ist.

70. Kollektor gemäß einem der Sätze 65 bis 68, wobei die Flächenfunktion K (z,Φ) unstetig In z und/oder Φ ist.

71. Kollektor gemäß Satz 70, wobei die Flächenfunktion eine mehrstückige Fläche ist

72. Kollektor gemäß Satz 69, wobei die Flächefunktion eine einstückige Fläche ist

73. Kollektor nach Satz 72, wobei die einstückige Flächenfunktion aus mehreren Flächensegmenten zusammengefügt ist.

74. Beleuchtungssystem für eine Wellenlänge≤193 nm, bevorzugt≤126 nm, insbesondere Im EUV-Wellenlängenbereich umfassend einen Kollektor (3), gemäß einem der Sätze 65 bis 73, wobei der Kollektor (852) im Lichtweg von einer Lichtquelle (1) zu einer Ebene (103, 1103), in der eine Ausleuchtung vorliegt, zwischen der Lichtquelle (1) und der Ebene (103, 1103) angeordnet ist und in oder nahe der Ebene (103) ein facettiertes optisches Element (102) zur Verfügung gestellt wird und in der Ebene eine Ausleuchtung zur Verfügung stellt.

75. Beleuchtungssystem nach Satz 74, wobei das facettierte optische Element (102) eine Vielzahl von Feldrasterelementen (402, 502,1300) umfasst.

76. Beleuchtungssystem nach Satz 75, wobei die Feldrasterelemente (1300) des facettierten optischen Elementes derart angeordnet sind, dass sie in der Ebene (1103) im Wesentlichen im Bereich der Ausleuchtung angeordnet sind.

77. Beleuchtungssystem nach einem der Sätze 74 bis 76, wobei das Beleuchtungssystem eine Austrittspupillenebene (140) und/oder eine Pupillenebene aufweist und das facettierte optische Element derart ausgebildet ist, dass unabhängig von einer Form Ausleuchtung in der Ebene (103) Lichtquellenbilder In eine Austrittspupillenebene (140) und/oder eine Pupillenebene (105) weitgehend objekttreu abgebildet werden.

78. Beleuchtungssystem gemäß Satz 77, wobei das facettierte optische Element Feldrasterelemente aufweist und die Feldrasterelemente eine optische Wirkung und eine Asphärizität aufweisen.

79. Beleuchtungssystem gemäß Satz 78, wobei die Asphärizität unterschiedlicher Feldrasterelemente verschieden ist.

80. Beleuchtungssystem nach einem der Sätze 75 bis 79, wobei das Beleuchtungssystem eine Pupillenebene (105) und ein weiteres facettiertes optisches Element (104) aufweist, wobei das weitere facettierte optische Element (104) in oder nahe der Pupillenebene (105) angeordnet ist.

81. Beleuchtungssystem nach Satz 80, wobei das weitere optische Element eine Vielzahl von Pupillenrasterelementen umfasst.

82. Beleuchtungssystem nach Satz 81, wobei Je einem einer Vielzahl von Feldrasterelementen ein Pupillenrasterelement gemäß einer ersten Zuordnung zugeordnet ist und Je einem einer zweiten Vielzahl von Feldrasterelementen ein Pupillenrasterelement gemäß einer zweiten Zuordnung zugeordnet ist.

83. Beleuchtungssystem nach Satz 82, wobei wenigstens die erste Fläche und/oder die zweite Fläche in eine erste Position und in eine zweite Position verbracht werden kann und in der ersten Position die erste Vielzahl von Feldrasterelementen und in der zweiten Position die zweite Vielzahl von Feldrasterelementen ausgeleuchtet wird.

84. Beleuchtungssystem nach Satz 82, wobei im Lichtweg nach dem Kollektor und vor dem facettierten optischen Element (102) ein optisches Einstellelement (10000) angeordnet ist, wobei das optische Einstellelement (10000) in einer ersten Position eine erste Vielzahl von Feldrasterelementen und in einer zweiten Position eine zweite Vielzahl von Feldrasterelementen ausleuchtet.

85. Beleuchtungssystem nach Satz 84, wobei in der ersten Position des optischen Einstellelementes (10000) ein erster Spiegel (8000) in den Lichtweg von der Lichtquelle zum facettierten optischen Element verbracht wird und in einer zweiten Position ein zweiter Spiegel (8002) in den Lichtweg von der Lichtquelle zum facettierten optischen Element verbracht wird.

86. Beleuchtungssystem nach Satz 82. wobei in den Lichtweg nach dem Kollektors und vor dem facettierten optischen Element unterschiedliche optische Elemente zur Ausleuchtung einer unterschiedlichen Vielzahl von Feldrasterelementen eingebracht werden.

87. Beleuchtungssystem nach Satz 86, wobei die unterschiedlichen optischen Elemente unterschiedliche Spiegel sind.

88. Beleuchtungssystem nach Satz 87, wobei die unterschiedlichen Spiegel auf einem um eine Achse drehbaren Spiegelträger angeordnet sind.

89. Beleuchtungssystem nach einem der Sätze 82 bis 88, wobei die erste Zuordnung einer erste Ausleuchtung in einer Austrittspupillenebene (140) und die zweite Zuordnung einer zweite Ausleuchtung in der Austrittspupillenebene (140) entspricht, wobei die erste Ausleuchtung verschieden von der zweiten Ausleuchtung ist.

90. Projektionsbelichtungsanlage für die Mikrolithographie mit Wellenlängen ≤ 193 nm, umfassend
eine Lichtquelle (1);
ein Beleuchtungssystem gemäß einem der Sätze 74 bis 89 zur Ausleuchtung eines Feldes in einer Feldebene(114) und
einem Projektionsobjektiv (128) um ein Objekt in der Feldebene (114) in ein Bild in einer Bildebene (124) des Projektionsobjektives (128) abzubilden.

91. Verfahren zur Herstellung mikroelektronischer Bauteile, umfassend die nachfolgenden Schritte:

es wird mit Hilfe einer Projektionsbelichtungsanlage gemäß Satz 90 eine strukturierte Maske auf eine lichtempfindliche Schicht, die sich in der Bildebene (124) des Projektionsobjektives befindet, abgebildet;
die strukturierte Maske wird entwickelt, ergebend einen Teil des mikroelektronische Bauteils oder das mikroelektronische Bauteil selbst.

92. Facettiertes optisches Element für ein Beleuchtungssystem für Wellenlängen s 193 nm, insbesondere ≤ 126 nm, besonders bevorzugt EUV-Wellenlängen umfassend:

ein erste Rasterelement mit einer ersten Asphärizität und ein zweites Rasterelement mit einer zweiten Asphärizität, wobei die erste Asphärizität verschieden von der zweiten Asphärizität ist.

93. Facettiertes optisches Element gemäß Satz 92, wobei das erste und das zweite Rasterelement asphärische Spiegelflächen sind.

**Patentansprüche**

1. Kollektor für Beleuchtungssysteme für eine Wellenlänge ≤ 193 nm, bevorzugt, ≤ 126 nm, besonders bevorzugt EUV-Strahlung, umfassend:

eine erste Spiegelschale (1212.1) und eine zweite Spiegeischale (1212.2), wobei die erste Spiegeischale (1212.1) innerhalb der zweiten Spiegelschale (1212.2) angeordnet ist, und die erste Spiegelschalen (1212.1) und/oder die zweite Spiegelschale (1212.2) eine geschlossene Spiegelfläche ist, die einen rotationssymmetrischen Anteil umfasst,
**dadurch gekennzeichnet, dass**
die erste Spiegelschale (1212.1) und/oder die zweite Spiegelschale (1212,2) einen nicht rotationssymmetrischen Anteil umfasst.

2. Kollektor gemäß Anspruch 1, wobei die erste (1212.1) und/oder die zweite Spiegelschale (1212.2) ein erstes Segment mit einer ersten optischen Fläche und ein zweites Segment mit einer zweiten optischen Fläche umfasst.

3. Kollektor gemäß Anspruch 2, wobei das erste Segment ein Rotationshyperboloid (800) ist und das zweite Segment ein Rotationsellipsoid (802) ist, wobei der nicht rotationssymmetrische Anteil zu dem Rotationshyperboloiden und/oder Rotationseilipsoiden hinzuaddiert oder abgezogen wird.

4. Kollektor gemäß einem der Ansprüche 1 bis 3, wobei wenigstens die erste Spiegelschale (1212.1) und/oder die zweite Spiegelschale (1212.2) eine Symmetrieachse aufweisen.

5. Kollektor gemäß einem der Ansprüche 1 bis 4, wobei der Kollektor Licht einer Lichtquelle aufnimmt und in eine Ebene, die im Lichtweg hinter dem Kollektor liegt, leitet, wobei der nicht rotationssymmetrische Anteil der geschlossenen Spiegelschale derart gewählt ist, dass in der Ebene eine Ausleuchtung im Wesentlichen in rechteckiger Form vorliegt.

6. Kollektor gemäß einem der Ansprüche 1 bis 5, wobei wenigstens die erste Spiegelschale (1212.1) und eine zweite Spiegelschale (1212.2) Licht in eine Ebene leiten, die in einem Lichtweg hinter dem Kollektor zum Liegen kommt, so dass in dieser Ebene eine erste Ausleuchtung (A6.1) und eine zweite Ausleuchtung (A6.2) ausgebildet wird, und erste und zweite Ausleuchtung (A6.1, A6.2) einen Abstand zueinander aufweisen.

7. Kollektor nach Anspruch 6, **dadurch gekennzeichnet, dass** der Abstand der ersten und der zweiten Ausleuchtung (A6.1, A6.2) derart gewählt ist, dass bei einer thermalen Deformation der ersten oder der zweiten Spiegelschale oder bei einer Veränderung der Lichtquelle in Form oder Abstrahlcharakteristik die erste und die zweite Ausleuchtung (A6.1. A6.2) in der Ebene nicht überlappen.

8. Kollektor nach einem der Ansprüche 6 bis 7, wobei in der Ebene eine Vielzahl von Rasterelementen in einer Anordnung mit einer Form zur Verfügung gestellt wird und die erste und/oder zweite Ausleuchtung (A6.1,A6.2) eine geometrische Form aufweist, die im Wesentlichen der Form der Anordnung der Vielzahl von Rasterelementen entspricht.

9. Kollektor für Beleuchtungssysteme für eine Wellenlänge ≤ 193 nm, bevorzugt ≤ 126 nm, besonders bevorzugt EUV-Strahlung, umfassend:

   wenigstens eine erste Fläche (850.1) und eine zweite Fläche (850.2), wobei die erste Fläche (850.1) beabstandet zur zweiten Fläche (850.2) ist, und die erste Fläche (850.1) einer ersten Achse (854.1) zugeordnet ist und die zweite Fläche (850.2) einer zweiten Achse (854.2) zugeordnet ist und wenigstens eine Flächenfunktion K1 der ersten Fläche und/oder eine Flächenfunktion K2 der zweiten Fläche eine Flächenfunktion $K(z, \Phi)$ ist, die durch die Lage entlang der zugeordneten Achse (z) und dem zugeordneten Azimutwinkel ($\Phi$) in einer Ebene (856,1, 856,2) senkrecht auf der zugeordneten Achse (z), definiert ist,
   **dadurch gekennzeichnet, dass**
   wenigstens eine Flächenfunktion $K(z, \Phi)$ bezüglich einer zugeordneten Achse einen rotationssymmetrischen Anteil und einen nicht rotationssymmetrischen Anteil umfasst.

10. Beleuchtungssystem für eine ≤ 193 nm, bevorzugt ≤ 126 nm, besonders bevorzugt EUV-Strahlung, umfassend einen Kollektor (3), gemäß einem der Ansprüche 1 bis 9, wobei der Kollektor (3) im Lichtweg von einer Lichtquelle (1) zu einer Ebene (103, 1103), in der eine Ausleuchtung vorliegt, zwischen der Lichtquelle (1) und der Ebene (103,1103) angeordnet ist und in oder nahe der Ebene (103) ein facettiertes optisches Element (102) zur Verfügung gestellt wird.

11. Beleuchtungssystem nach Anspruch 10, wobei das facettierte optische Element (102) eine Vielzahl von Feldrasterelementen (402, 502, 1300) umfasst und die Feldrasterelemente (1300) des facettierten optischen Elementes derart angeordnet sind, dass sie in der Ebene (1103) im Wesentlichen im Bereich der Ausleuchtung (A6.1, A6.2, A6.3) angeordnet sind.

12. Beleuchtungssystem nach einem der Ansprüche 9 bis 10, wobei das Beleuchtungssystem eine Austrittspupillenebene (140) und/oder eine Pupillenebene aufweist und das facettierte optische Element derart ausgebildet ist, dass unabhängig von einer Form der Ausleuchtung in der Ebene (103) Lichtquellenbilder in eine Austrittspupillenebene (140) und/oder eine Pupillenebene (105) weitgehend objekttreu abgebildet werden.

13. Beleuchtungssystem gemäß Anspruch 12, wobei das facettierte optische Element Feldrasterelemente aufweist und die Feldrasterelemente eine optische Wirkung und eine Asphärizität aufweisen.

**14.** Beleuchtungssystem gemäß Anspruch 13, wobei die Asphärizität unterschiedlicher Feldrasterelemente verschieden ist.

**15.** Beleuchtungssystem nach einem der Ansprüche 10 bis 14, wobei das Beleuchtungssystem eine Pupillenebene (105) und ein weiteres facettiertes optisches Element (104) aufweist, wobei das weitere facettierte optische Element (104) in oder nahe der Pupillenebene (105) angeordnet ist.

**16.** Beleuchtungssystem nach Anspruch 15, wobei das weitere optische Element eine Vielzahl von Pupillenrasterelementen umfasst und je einem einer ersten Vielzahl von Feldrasterelementen ein Pupillenrasterelement gemäß einer ersten Zuordnung zugeordnet ist und je einem einer zweiten Vielzahl von Feldrasterelementen ein Pupillenrasterelement gemäß einer zweiten Zuordnung zugeordnet ist.

**17.** Beleuchtungssystem nach Anspruch 16, wobei das Beleuchtungssystem ein erstes und/oder ein zweites Spiegelsegment (1500.1, 1500.2, 1500.3, 1500.4) umfasst und das erste Segment (1500.1, 1500.2, 1500.3, 1500.4) und/oder das zweite Segment in eine erste Position und in eine zweite Position (1500.28) verbracht werden kann und in der ersten Position (1500.2A) die erste Vielzahl von Feldrasterelementen und in der zweiten Position (1500.28) die zweite Vielzahl von Feldrasterelementen ausgeleuchtet wird.

**18.** Beleuchtungssystem nach Anspruch 16, wobei im Lichtweg nach dem Kollektor und vor dem facettierten optischen Element (102) ein optisches Einstellelement (10000) angeordnet ist, wobei das optische Einstellelement (10000) in einer ersten Position die erste Vielzahl von Feldrasterelementen und in einer zweiten Position die zweite Vielzahl von Feldrasterelementen ausleuchtet.

**19.** Beleuchtungssystem nach Anspruch 18, wobei in der ersten Position des optischen Einstellelementes (10000) ein erster Spiegel (8000) in den Lichtweg von der Lichtquelle zum facettierten optischen Element verbracht wird und in einer zweiten Position ein zweiter Spiegel (8002) in den Lichtweg von der Lichtquelle zum facettierten optischen Element verbracht wird.

**20.** Beleuchtungssystem nach Anspruch 18, wobei in den Lichtweg nach dem Kollektor und vor dem facettierten optischen Element unterschiedliche optische Elemente zur Ausleuchtung der ersten Vielzahl von Feldrasterelementen und/oder der zweiten Vielzahl von Feldrasterelementen eingebracht werden.

**21.** Beleuchtungssystem nach Anspruch 20, wobei die unterschiedlichenoptischen Elemente unterschiedliche Spiegel und die unterschiedlichen Spiegel auf einem um eine Achse drehbaren Spiegelträger angeordnet sind.

**22.** Beleuchtungssystem nach einem der Ansprüche 16 bis 21, wobei die erste Zuordnung einer erste Ausleuchtung in einer Austrittspupillenebene (140) und die zweite Zuordnung einer zweite Ausleuchtung in der Austrittspupillenebene (140) entspricht, wobei die erste Ausleuchtung verschieden von der zweiten Ausleuchtung ist.

**23.** Projektionsbelichtungsanlage für die Mikrolithographie mit Wellenlängen $\leq$ 193 nm, umfassend
eine Lichtquelle (1);
ein Beleuchtungssystem gemäß einem der Ansprüche 10 bis 22 zur Ausleuchtung eines Feldes in einer Feldebene (114) und
einem Projektionsobjektiv (128) um ein Objekt in der Feldebene (114) in ein Bild in einer Bildebene (124) des Projektionsobjektives (128) abzubilden.

**24.** Verfahren zur Herstellung mikroelektronischer Bauteile, umfassend die nachfolgenden Schritte:

es wird mit Hilfe einer Projektionsbelichtungsanlage gemäß Anspruch 23 eine strukturierte Maske auf eine lichtempfindliche Schicht, die sich in der Bildebene (124) des Projektionsobjektives befindet, abgebildet;
die strukturierte Maske wird entwickelt, ergebend einen Teil des mikroelektronische Bauteils oder das mikroelektronische Bauteil selbst.

**Claims**

**1.** Collector for illumination systems for a wavelength of $\leq$ 193 nm, preferably $\leq$ 126 nm, particularly preferably EUV radiation, comprising:

a first mirror shell (1212.1) and a second mirror shell (1212.2), wherein the first mirror shell (1212.1) is arranged with in the second mirror shell (1212.2),

and the first mirror shell (1212.1) and/or the second mirror shell (1212.2) are/is a closed mirror surface comprising a rotationally symmetrical portion,

**characterized in that**

the first mirror she 11 (1212.1) and/or the second mirror shell (1212.2) comprise(s) a non -rotationally symmetrical portion.

2.  Collector according to Claim 1, wherein the first (1212.1) and/or the second mirror shell (1212.2) comprise(s) a first segment having a first optica 1 surface and a second segment having a second optical surface.

3.  Collector according to Claim 2, wherein the first segment is a hyperboloid (800) of revolution and the second segment is an ellipsoid (802) of revolution, wherein the non -rotationally symmetrical portion is added to or subtracted from the hyperboloid of revolution and/or ellipsoid of revolution.

4.  Collector according to any of Claims 1 to 3, wherein at least the first mirror shell (1212.1) and/or the second mirror shell (1212.2) have/has an axis of symmetry.

5.  Collector according to any of Claims 1 to 4, wherein the collector takes up light from a light source and directs it into a plane lying in the light path downstream of the collector, wherein the non - rotationally symmetrical portion of the closed mirror shell is chosen in such a way that in the plane an illumination is present substantially in rectangular form.

6.  Collector according to any of Claims 1 to 5, wherein at least the first mirror shell (1212.1) and a second mirror shell (1212.2) direct light into a plane located in a light path downstream of the collector, such that a first illumination (A6.1) and a second illumination (A6.2) are formed in said plane and first and second illuminations (A6.1, A6.2) are at a distance from one another.

7.  Collector according to Claim 6, **characterized in that** the distance between the first and second illuminations (A6.1, A6.2) is chosen in such a way that, in the case of a thermal deformation of the first or of the second mirror shell or in the case of an alteration of the light source in terms of form or emission characteristic, the first and second illuminations (A6.1, A6.2) do not overlap in the plane.

8.  Collector according to either of Claims 6 and 7, wherein in the plane a multiplicity of raster elements are made available in an arrangement having a form and the first illumination and/or second illumination (A6.1, A6.2) have/has a geometrical form which substantially corresponds to the form of the arrangement of the multiplicity of raster elements.

9.  Collector for illumination systems for a wavelength of ≤ 193 nm, preferably ≤ 126 nm, particularly preferably EUV radiation comprising:

    at least one first surface (850.1) and one second surface (850.2) wherein the first surface (850.1) is a t a distance from the second surface (850.2), and the first surface (850.1) is assigned to a first axis (854.1) and the second surface (850.2) is assigned to a second axis (854.2) and at least one surface function K1 of the first surface and/or a surface function K2 of the second surface are/is a surface function $K(z, \Phi)$,

    which is defined by the position along the assigned axis (z) and the assigned azimuth angle ($\Phi$) in a plane (856.1, 856.2) perpendicular to the assigned axis (z), **characterized in that**

    at least one surface function $K(z, \Phi)$, with respect to an assigned a xis, comprises a rotationally symmetrical portion and a non-rotationally symmetrical portion.

10. Illumination system for a ≤ 193 nm, preferably ≤ 126 nm, particularly preferably EUV, radiation, comprising a collector (3), according to any of Claims 1 to 9, wherein the collector (3), in the li ght path from a light source (1) to a plane (103, 1103) in which an illumination is present, is arranged between the light source (1) and the plane (103, 1103) and a faceted optical element (102) is made available in or near the plane (103).

11. Illumination system according to Claim 10, wherein the faceted optical element (102) comprises a multiplicity of field raster elements (402, 502, 1300) and the field raster elements (1300) of the faceted optical element are ar ranged in such a way that they are arranged in the plane (1103) substantially in the region of the illumination (A6.1, A6.2, A6.3).

12. Illumination system according to either of Claims 9 and 10, wherein the illumination system has an exit pupil plane (140) and/or a pupil plane and the faceted optical element is formed in such a way that, independently of a form of the illumination in the plane (103), light source images are imaged largely object-faithfully into an exit pupil plane (140) and/or a pupil plane (105).

13. Illumination system according to Claim 12, wherein the faceted optical element has field raster elements and the field raster elements have an optical effect and an asphericity.

14. Illumination system according to Claim 13 , wherein the asphericity of different field raster elements is different.

15. Illumination system according to any of Claims 10 to 14, wherein the illumination system has a pupil plane (105) and a further faceted optical element (104), wherein the further faceted optical element (104) is arranged in or near the pupil plane (105).

16. Illumination system according to Claim 15, wherein the further optical element comprises a multiplicity of pupil raster elements and a respective one of a first multiplicity of field raster elements is assigned a pupil raster element in accordance with a first assignment and a respective one of a second multiplicity of field raster elements is assigned a pupil raster element in accordance with a second assignment.

17. Illumination system according to Claim 16, wherein the illumination system comprises a first and/or a second mirror segment (1500.1, 1500.2, 1500.3, 1500.4) and the first segment (1500.1, 1500.2, 1500.3, 1500.4) and/or the second segment can be brought into a first position and into a second position (1500.28) and the first multiplicity of field raster elements is illuminated in the first position (1500.2A) and the second multiplicity of field raster elements is illuminated in the second position (1500.28).

18. Illumination system according to Claim 16, wherein an optical setting element (10000) is arranged in the light path downstream of the collector and upstream of the faceted optical element (102), wherein the optical setting element (10000) illuminates the first multiplicity of field raster elements in a first position and the second multiplicity of field raster elements in a second position.

19. Illumination system according to Claim 18, wherein, in the first position of the optical setting element (10000), a first mirror (8000) is brought into the light path from the light source to the faceted optical element, and, in a second position, a second mirror (8002) is brought into the light path from the light source to the faceted optical element.

20. Illumination system according to Claim 18, wherein different optical elements for illuminating the first multiplicity of field raster elements and/or the second multiplicity of field raster elements were introduced into the light path downstream of the collector and upstream of the faceted optical element.

21. Illumination system according to Claim 20, wherein the different optical elements are different mirrors and the different mirrors are arranged on a mirror carrier, which is rotatable about an axis.

22. Illumination system according to any of Claims 16 to 21, wherein the first assignment corresponds to a first illumination in an exit pupil plane (140) and the second assignment corresponds to a second illumination in the exit pupil plane (140), wherein the first illumination is different from the second illumination.

23. Projection exposure apparatus for microlithography with wavelengths of ≤ 193 nm, comprising
a light source (1);
an illumination system according to any of Claims 10 to 22 for illuminating a field in a field plane (114), and
a projection objective (128) for imaging an object in the field plane (114) into an image in an image plane (124) of the projection objective (128).

24. Method for producing microelectronic components, comprising the following steps:

with the aid of a projection exposure apparatus according to Claim 23 a patterned mask is imaged onto a light-sensitive layer situated in the image plane (124) of the projection objective;
the patterned mask is developed, producing a part of the microelectronic component or the microelectronic component itself.

**Revendications**

1. Collecteur pour systèmes d'éclairage pour une longueur d'ondes ≤ 193 nm, de préférence ≤ 126 nm, de préférence particulière pour du rayonnement EUV, comportant :

   une première coupole spéculaire (1212.1) et une deuxième coupole spéculaire (1212.2), la première coupole spéculaire (1212.1) étant disposée à l'intérieur de la deuxième coupole spéculaire (1212.2), et la première coupole spéculaire (1212.1) et/ou la deuxième coupole spéculaire (1212.2) étant une surface spéculaire fermée comportant une partie symétrique par révolution,
   **caractérisé en ce que**
   la première coupole spéculaire (1212.1) et/ou la deuxième coupole spéculaire (1212.2) comporte nt une partie non symétrique par révolution.

2. Collecteur selon la revendication 1, dans lequel la première (1212.1) et/ou la deuxième coupole spéculaire (1212.2) comportent un premier segment avec une première surface optique et un deuxième segment avec une deuxième surface optique.

3. Collecteur selon la revendication 2, dans lequel le premier seg ment est un hyperboloïde de révolution (800) et le deuxième segment un ellipsoïde de révolution (802), la partie non symétrique par révolution étant ajoutée ou soustraite à l'hyperboloïde de révolution et/ou à l'ellipsoïde de révolution.

4. Collecteur sel on une des revendications 1 à 3, dans lequel au moins la première coupole spéculaire (1212.1) et/ou la deuxième coupole spéculaire (1212.2) comportent un axe de symétrie.

5. Collecteur selon une des revendications 1 à 4, dans lequel le collecteur recueille la lumière d'une source lumineuse et la guide vers un plan situé sur le chemin de la lumière derrière le collecteur, la partie non symétrique par révolution de la coupole spéculaire fermée étant choisie de telle sorte que l'illumination du plan soit de forme essentiellement rectangulaire.

6. Collecteur selon une des revendications 1 à 5, dans lequel au moins la première coupole spéculaire (1212.1) et une deuxième coupole spéculaire (1212.2) guident la lumière vers un plan qui se trouve disposé sur un chemin de la lumière derrière le collecteur, de manière à former dans ce plan, une première illumination (A6.1) et une deuxième illumination (A6.2), la première et la deuxième illumination (A6.1, A6.2) présentant un écart l'une par rapport à l'autre.

7. Collecteur selon la revendication 6, **caractérisé en ce que** l'écart entre la première et la deuxième illumination (A6.1, A6.2) est choisi de telle sorte que la première et la deuxième illumination (A6.1, A6.2) ne se superposent pas dans le plan lors d'une déformation thermique de la première ou de la deuxième coupole spéculaire ou lors d'une modification de la forme ou des caractéristiques d'émission de la source lumineuse.

8. Collecteur selon une des revendications 6 à 7, dans lequel on peut disposer d'une multitude d'éléments de trame disposés selon une forme, et dans lequel la première et/ou deuxième illumination (A6.1, A6.2) présentent une forme géométrique correspondant pour l'essentiel à la forme de la disposition de la multitude d'éléments de trame.

9. Collecteur pour systèmes d'éclairage pour une longueur d'ondes ≤ 193 nm, de préférence ≤ 126 nm, particulièrement préféré du rayonnement EUV, comportant :

   au moins une première surface (850.1) et une deuxième surface (850.2), la première surface (850.1) étant écartée de la deuxième surface (850.2) et la première surface (850.1) étant affectée à un premier axe (854.1) et la deuxième surface (850.2) à un deuxième axe (854.2), et au moins une fonction de surface K1 de la première surface et/ou une fonction de surface K2 de la deuxième surface étant une fonction de surface $K(z, \Phi)$ définie par la position le long de l'axe (z) qui lui est attribué et par l'angle azimutal ($\Phi$) qui lui est attribué dans un plan (856.1, 856.2) perpendiculaire à l'axe (z) qui lui est attribué,
   **caractérisé en ce que**
   au moins une fonction de surface $K(z, \Phi)$ correspondant à un axe qui lui est attribué comporte une partie symétrique par révolution et une partie non symétrique par révolution.

10. Système d'éclairage pour une longueur d'ondes ≤ 193 nm, de préférence ≤ 126 nm, particulièrement préféré pour du rayonnement EUV, comportant un collecteur (3) selon une des revendications 1 à 9, dans lequel le collecteur (3) est disposé sur le chemin de la lumière d'une source lumineuse (1) vers un plan (103, 1103) illuminé, entre la source lumineuse (1) et le plan (103, 1103) et un élément optique à facettes (102) étant mis à disposition dan s le plan (103) ou à proximité.

11. Système d'éclairage selon la revendication 10, dans lequel l'élément optique à facettes (102) comporte une multitude d'éléments de trame de champ (402, 502, 1300) et les éléments de trame de champ (1300) de l'élément optique à facettes sont disposés de telle sorte qu'ils sont disposés dans le plan (1103) essentiellement dans le domaine de l'illumination (A6.1, A6.2, A6.3).

12. Système d'éclairage selon une des revendications 9 à 10, dans lequel le système d'éclairage comporte un plan de pupille de sortie (140) et/ou un plan de pupille et l'élément optique à facettes est réalisé de telle sorte que les images de la source lumineuse sont représentées dans un plan de pupille de sortie (140) et/ou un plan de pupille (105) de manière largement fidèle à l'objet indépendamment d'une forme de l'illumination dans le plan (103).

13. Système d'éclairage selon la revendication 1 2, dans lequel l'élément optique à facettes comporte des éléments de trame de champ et les éléments de trame de champ comportent un effet optique et une caractéristique asphérique.

14. Système d'éclairage selon la revendication 13, dans lequel la caractéristique asphérique est différente pour les différents éléments de trame de champ.

15. Système d'éclairage selon une des revendications 10 à 14, dans lequel le système d'éclairage comporte un plan de pupille (105) et un autre élément optique à facettes (104), l'autre élément optique à facettes (104) étant disposé dans le plan de pupille (105) ou à proximité.

16. Système d'éclairage selon la revendication 15, dans lequel l'autre élément optique comporte une multitude d'éléments de trame de pupille et selon une première attribution, on attribue un élément de trame de pupille à chacun d'une première multitude d'éléments de trame de champ et selon une deuxième attribution, on attribue un élément de trame de pupille à chac un d'une deuxième multitude d'éléments de trame de champ.

17. Système d'éclairage selon la revendication 16, dans lequel le système d'éclairage comporte un premier et/ou un deuxième segment spéculaire (1500.1, 1500.2, 1500.3, 1500.4) et dans lequel le premier segment (1500.1, 1500.2, 1500.3, 1500.4) et/ou le deuxième segment peuvent être mis dans une première position et dans une deuxième position (1500.28) et dans lequel la première multitude d'éléments de trame de champ est illuminée dans le première position (1500.2A) et la deuxième multitude d'éléments de trame de champ dans la deuxième position (1500.28).

18. Système d'éclairage selon la revendication 16, dans lequel un élément de réglage optique (10000) est disposé sur le chemin de lumière après le collecteur et devant l'élément optique à facettes (102), dans lequel l'élément de réglage optique (10000) illumine la première multitude d'éléments de trame de champ dans une première position et la deuxième multitude d'éléments de trame de champ dans une deuxième position.

19. Système d'éclairage selon la revendication 18, dans lequel un premier miroir (8000) est mis sur le chemin de lumière de la source lumineuse à l'élément optique à facettes dans la première position de l'élément de réglage optique (10000) et un deuxième miroir (8002) est mis sur le chemin de lumière de la source lumineuse à l'élément optique à facettes dans une deuxième position.

20. Système d'éclairage selon la revendication 18, dans lequel on introduit différents éléments optiques sur le chemin de lumière après le collecteur et devant l'élément optique à facettes pour l'illumination de la première multitude d'éléments de trame de champ et/ou de la deuxième multitude d'éléments de trame de champ.

21. Système d'éclairage selon la revendication 20, dans lequel les différents éléments optiques sont différents miroirs et les différents miroirs sont disposés sur un support de miroir pivotant autour d'un axe.

22. Système d'éclairage selon une des revendications 16 à 21, dans lequel la première attribution correspond à une première illumination dans un plan de pupille de sortie (140) et la deuxième attribution correspond à une deuxième illumination dans le plan de pupille de sortie (140), la première illumination étant différente de la deuxième illumination.

23. Installation d'insolation par projection pour la microlithographie avec des longueurs d'ondes ≤ 193 nm, comportant une source lumineuse (1),

un système d'éclairage selon une des revendications 10 à 22 pour l'illumination d'un champ da ns un plan de champ (114) et

un objectif de projection (128) pour représenter un objet dans le plan de champ (114) sous la forme d'une image dans un plan image (124) de l'objectif de projection (128).

24. Procédé de fabrication de composants microélectroniques, comportant les étapes suivantes :

à l'aide d'une installation d'insolation par projection selon la revendication 23, on reproduit un masque structuré sur un couche photosensible se trouvant dans le plan image (124) de l'objectif de projection,
on révèle le masque structuré ce qui produit une partie du composant microélectronique ou le composant microélectronique lui-même.

Fig. λ

EP 1 938 150 B1

FIG. 2

A1

400.1

400.2

402

402

FIG. 3

A2

500.1

502

500.2

Fig. 4a

undeformierte
Kollektorschale

Fig. 4b

deformierte
Kollektorschale

Fig. 4c

Fig. 4d

Beiträge
einzelner Schalen

Mittenobskuration

Beiträge
einzelner Schalen

Fig 5a

Fig. 5b

852

δ

z=0

850.1

K.1(z,φ)

.8563

z=0

x

φ

856.1

Lichtquelle

856.2

z=z₁

850.2

854.1

z

K2(z,φ)

z=z'₁

φ

x

z

854.2

auszuleuchtende Ebene

EP 1 938 150 B1

Fig. 5c

Fig. 6

Fig. 7

asphärischer Spiegel

Gitter mit opt. Wirkung

0. Beugungsordnung

EP 1 938 150 B1

Fig. 8a

EP 1 938 150 B1

Fig. 8b

Beitrag Schale 1
AS.1
Beitrag Schale 2
AS.2
Beitrag Schale 3
AS.3

AS.4
AS.5

SMA

Mittenobskuration

Fig. 8c

SE1(x)  SE2(x)  SE(x)  SEG(x)

SE3(x)

x

| | Schale 1 |
| | Schale 2 |
| | Schale 3 |
| | alle Schalen |

Schale 1

x

y

1212.1

1212.2

1214.1

1214.2

1218.1

1103

Fig. 9a

Quelle

z

Schale 2

IF

Ausleuchtung
Schale 2

A 6.1

unausgeleuchteter
Bereich

1216.1

B SM

1216.2

1218.2

A6.2

NA_Min

AB

Ausleuchtung
Schale 1

FF-Ebene

y

AB1

Beitrag Schale 1

Beitrag Schale 2

Beitrag Schale 3

A6.1

x

A6.2

A6.3

Fig 9S

nicht ausgeleuchtete
Bereiche

SM

AB2

38

Fig. 9c

Fig. 9d

Segment 2a        Segment 2b

1400.4

1400.3

1400.2

1400.1

Segment 1a        Segment 1b

Fig. 10a

Fig. 105.1

Beitrag
Segment 2b

Beitrag
Segment 2a

AB

1402.1

Feldfacetten

A7.1a   A8.1a   A8.2a   AB   A7.2a

AB

Beitrag
Segment 1b

Beitrag
Segment 1a

1402.2   AB   Fig. 105.2

1402.2

A7.1.5   A8.1.5   A8.2.5   A7.2.5.

AB

Fig. 11a

Segment 1b
Position 2

1500.3

1500.4

1500.2

1502.B

Segment 1b
Position 1

1500.1

1500.2A

Fig. 11b

Beitrag
Segment 2b

Beitrag
Segment 2a

1400

Beitrag Segment 1b
Position 2

A9.1A

Feldfacetten

Beitrag Segment 1b
Position 1

A9.1B

A9.2

110.1   A10.2

Beitrag
Segment 1a

ausgeleuchtete
Pupillenfacette

1600

1602,   Fig. 12a

nicht ausgeleuchtete
Pupillenfacette

ausgeleuchtete
Pupillenfacette

Fig. 12b

1600

nicht ausgeleuchtete
Pupillenfacette

10000

10004

8000

von der
Lichtquelle

10002

A

Fig. 13a

9002.1

10004.1

9002.2

10000

10004    8002

von der
Lichtquelle

8004.2

8004.1

10004.2

A

Fig. 13b

30020   30000   30010  30012

30002

30022

Fig. 13c

35000

40000

Fig. 13d

35002   35002

40002

Fig. 13e

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 60727892 B
- US 20030043455 A1
- WO 03083579 A
- WO 9957732 A
- WO 02065482 A
- EP 0200608 W
- WO 02065482 A2
- US 6658084 B2
- US 20020186811 A1
- US 6198793 B1
- US 20020136351 A1
- US 6195201 B
- US 6600552 B2
- US 6658084 B